# EUROPEAN PATENT APPLICATION

(11) **EP 4 568 456 A1**
(43) Date of publication of application: **11.06.2025**
(21) Application number: 24216230.3
(22) Date of filing: 28.11.2024
(51) Int. Cl.: H10H 29/32, H10H 29/39, H10H 29/37

(54) **DISPLAY DEVICE**

(30) Priority: 08.12.2023 KR 20230177675; 15.07.2024 KR 20240093097
(71) Applicant: LG Display Co., Ltd., Seoul 07336 (KR)
(72) Inventor: LEE, Soyoung, 10845 GYEONGGI-DO (KR); LEE, Soyi, 10845 GYEONGGI-DO (KR); JANG, YoungIn, 10845 GYEONGGI-DO (KR); LIM, KwangSu, 10845 GYEONGGI-DO (KR); KIM, HyunGon, 10845 GYEONGGI-DO (KR); LEE, Junhyeok, 10845 GYEONGGI-DO (KR)
(74) Representative: Ter Meer Steinmeister & Partner

(57) **Abstract**

Provided is a display device. The display device includes a substrate including a plurality of sub pixels, a plurality of light emitting diodes which is disposed on the substrate in the plurality of sub pixels and each includes a first electrode and a second electrode disposed in a position higher than the first electrode, a first planarization layer which is disposed on the substrate so as to enclose a part of side surfaces of the plurality of light emitting diodes, a plurality of first connection electrodes which is disposed on the first planarization layer and is connected to the first electrode; a second planarization layer disposed on the first planarization layer and the plurality of first connection electrodes, and a plurality of second connection electrodes which is disposed on the second planarization layer and is connected to the second electrode. Therefore, the short defect may be minimized or reduced.

## Description

This application claims the benefit and priority to Republic of Korea Patent Application No. 10-2023-0177675 filed on December 8, 2023, and Republic of Korea Patent Application No. 10-2024-0093097 filed on July 15, 2024.

### Technical Field

The present disclosure relates to a display device, and more particularly, for example, without limitation, to a display device in which a short defect between electrodes is minimized or reduced.

### Description of the Related Art

As display devices which are used for a monitor of a computer, a television, or a cellular phone, there are an organic light emitting display device (OLED) which is a self-emitting device, a liquid crystal display device (LCD) which requires a separate light source, and the like.

An applicable range of the display device is diversified to personal digital assistants as well as monitors of computers and televisions and a display device with a large display area and a reduced volume and weight is being studied.

Further, recently, a display device including a light emitting diode (LED) which may be made of inorganic materials is attracting attention as a next generation display device. Since the LED is formed of an inorganic material, rather than an organic material, reliability is excellent so that a lifespan thereof is longer than that of the liquid crystal display device or the organic light emitting display device. Further, the LED has a fast-lighting speed, excellent luminous efficiency, and a strong impact resistance so that a stability is excellent and an image having a high luminance can be displayed.

The description provided in the background section should not be assumed to be prior art merely because it is mentioned in or associated with the background section. The background section may include information that describes one or more embodiments of the subject technology.

### SUMMARY

An embodiment of the present disclosure is to provide a display device which enables self-alignment of a first connection electrode and a first electrode of a light emitting diode.

An embodiment of the present disclosure is to provide a display device which enables self-alignment of a second connection electrode and a second electrode of a light emitting diode.

Another embodiment of the present disclosure is to provide a display device which separates an area in which a passivation film below a light emitting diode is torn and a first connection electrode to minimize or reduce a short defect of the first connection electrode.

An embodiment of the present disclosure is to provide a display device in which a short defect is minimized or reduced.

An embodiment of the present disclosure is to provide a display device which suppresses a short defect to be driven with a low power in terms of reduction of a power consumption.

Another embodiment of the present disclosure is to provide a display device which is easily repaired.

Embodiments of the present disclosure are not limited to the above-mentioned embodiments, and other embodiments, which are not mentioned above, can be clearly understood by those skilled in the art from the following descriptions.

The object is solved by the features of the independent claims. Preferred embodiments are given in the dependent claims.

To achieve these and other embodiments of the inventive concepts, as embodied and broadly described herein, a display device includes a substrate including a plurality of sub pixels, a plurality of light emitting diodes which is disposed on the substrate in the plurality of sub pixels and each includes a first electrode and a second electrode disposed in a position higher than the first electrode, a first planarization layer which is disposed on the substrate so as to enclose a part of side surfaces of the plurality of light emitting diodes, a plurality of first connection electrodes which is disposed on the first planarization layer and is connected to the first electrode; a second planarization layer disposed on the first planarization layer and the plurality of first connection electrodes, and a plurality of second connection electrodes which is disposed on the second planarization layer and is connected to the second electrode. Therefore, the short defect may be minimized or reduced.

In one or more embodiments, a height of an upper surface of the first planarization layer may be lower than a height of an upper surface of the first electrode.

In one or more embodiments, the part of the side surfaces of the plurality of light emitting diodes may be in contact with the first planarization layer.

In one or more embodiments, the second planarization layer may be between the plurality of first connection electrodes and the plurality of second connection electrodes.

In one or more embodiments, the second planarization layer may fully cover the plurality of first connection electrodes.

In one or more embodiments, the display device may further comprise a bank on the second planarization layer.

In one or more embodiments, the bank may be non-overlapping with the plurality of light emitting diodes.

In one or more embodiments, the display device may further comprise a third planarization layer on the second planarization layer and the bank.

In one or more embodiments, the plurality of first connection electrodes may include a plurality of first sub electrodes that are spaced apart from each other.

In one or more embodiments, the plurality of second connection electrodes may include a plurality of second sub electrodes that may be spaced apart from each other.

In one or more embodiments, the plurality of first sub electrodes and the plurality of second sub electrodes may be alternately disposed on a plane.

In one or more embodiments, the plurality of first connection electrodes may further include first base electrodes connected to the plurality of first sub electrodes.

In one or more embodiments, the plurality of second connection electrodes may further include second base electrodes connected to the plurality of second sub electrodes.

In one or more embodiments, a width of each of the plurality of first sub electrodes may be equal to or smaller than an interval between the plurality of second sub electrodes.

In one or more embodiments, a width of each of the plurality of second sub electrodes may be equal to or smaller than an interval between the plurality of first sub electrodes.

In one or more embodiments, the plurality of first sub electrodes and the plurality of second sub electrodes may be parallel on the plane.

In one or more embodiments, the plurality of light emitting diodes may include a first light emitting diode having a circular planar shape, a second light emitting diode having an oval planar shape, and a third light emitting diode having an oval planar shape which has a different size from that of the oval planar shape of the second light emitting diode.

In one or more embodiments, wherein a major axis direction of the second light emitting diode and a major axis direction of the third light emitting diode may be a same.

In one or more embodiments, the plurality of first sub electrodes and the plurality of second sub electrodes may be parallel to the major axis direction of the second light emitting diode and the third light emitting diode.

In one or more embodiments, the plurality of light emitting diodes may include a first light emitting diode having a circular planar shape, a second light emitting diode having an oval planar shape, and a third light emitting diode having an oval planar shape which may have a different size from that of the oval planar shape of the second light emitting diode.

In one or more embodiments, a major axis direction of the second light emitting diode and a major axis direction of the third light emitting diode may be a same.

In one or more embodiments, the plurality of first sub electrodes and the plurality of second sub electrodes may be perpendicular to the major axis direction of the second light emitting diode and the third light emitting diode.

In one or more embodiments, the plurality of light emitting diodes may include a first light emitting diode having a circular planar shape.

In one or more embodiments, the plurality of first sub electrodes connected to the first light emitting diode may have a circular shape with one open side on the plane.

In one or more embodiments, one of the plurality of second sub electrodes connected to the first light emitting diode may have a circular shape and others of the plurality of second sub electrodes have a circular shape in which another side opposite to the one open side of the plurality of first sub electrodes is open.

In one or more embodiments, the plurality of first connection electrodes may further include first base electrodes that are connected to the plurality of first sub electrodes and are in an open area of the plurality of second sub electrodes.

In one or more embodiments, the plurality of second connection electrodes may further include second base electrodes that are connected to the plurality of second sub electrodes and are in an open area of the plurality of first sub electrodes.

In one or more embodiments, the plurality of first sub electrodes may include a first part extending in a first direction and a second part extending in a second direction different from the first direction on the plane.

In one or more embodiments, the plurality of second sub electrodes may include a first part extending in the first direction and a second part extending in the second direction.

In one or more embodiments, the first part of the plurality of first sub electrodes and the first part of the plurality of second sub electrodes may be alternately disposed on the plane.

In one or more embodiments, the second part of the plurality of first sub electrodes and the second part of the plurality of second sub electrodes may be alternately disposed on the plane.

In one or more embodiments, the plurality of first sub electrodes and the plurality of second sub electrodes may be non-overlapping with each other on the plane.

In one or more embodiments, the display device may further comprise a plurality of driving transistors on the substrate; and a power line on the substrate.

In one or more embodiments, the plurality of first connection electrodes may electrically connect the plurality of driving transistors and the first electrode and the plurality of second connection electrodes may electrically connect the power line and the second electrode.

In one or more embodiments, a height of an upper surface of the second planarization layer may be lower than a height of an upper surface of the second electrode.

In one or more embodiments, each of the plurality of light emitting diodes may further include a first semiconductor layer below the first electrode and in contact with the first electrode, and a passivation film that surrounds the first semiconductor layer.

In one or more embodiments, the first planarization layer may fully cover a lower end of the passivation film.

In another aspect which might be combined with the optional features mentioned above a display device is provided, comprising: a substrate including a plurality of sub pixels that each including a light emitting diode, the light emitting diode including a first electrode and a second electrode in a position higher than the first electrode, a first connection electrode connected to the first electrode; a second connection electrode connected to the second electrode; a planarization layer between the first connection electrode and the second connection electrode, wherein the first connection electrode includes a plurality of first sub electrodes that are spaced apart from each other, the second connection electrode includes a plurality of second sub electrodes that are spaced apart from each other, and the plurality of first sub electrodes and the plurality of second sub electrodes are alternately disposed on a plane.

Other detailed matters of the exemplary embodiments are included in the detailed description and the drawings.

According to the embodiment of the disclosure, a first connection electrode and a second connection electrode are connected to a light emitting diode by a self-alignment manner without a separate alignment process by means of an ashing process of a first planarization layer and a second planarization layer to ensure a transfer margin.

According to the embodiment of the disclosure, the first planarization layer is filled in an area in which a passivation film below the light emitting diode is torn and the first connection electrode is disposed on the first planarization layer to minimize or reduce the short defect of the first connection electrode due to the torn passivation film.

According to the embodiment of the disclosure, a first sub electrode and a second sub electrode are separated on the plane to minimize or reduce a short defect caused by misalignment of the first sub electrode and the second sub electrode due to a process error. According to the exemplary embodiment of the present disclosure, only a part of a first sub electrode or a second sub electrode which is in contact with a defective light emitting diode is cut with laser to easily repair.

According to the embodiment of the disclosure, a display device which suppresses a short defect to be driven with a low power in terms of reduction of a power consumption is provided.

The effects according to the disclosure are not limited to the contents exemplified above, and more various effects are included in the present specification.

It is to be understood that both the foregoing general description and the following detailed description are exemplary and explanatory and are intended to provide further explanation of the inventive concepts as claimed.

### BRIEF DESCRIPTION OF DRAWINGS

The accompanying drawings, that may be included to provide a further understanding of the disclosure and may be incorporated in and constitute a part of the disclosure, illustrate embodiments of the disclosure and together with the description serve to explain various principles of the disclosure.

The above and other embodiments, features and other advantages of the present disclosure will be more clearly understood from the following detailed description taken in conjunction with the accompanying drawings, in which:
FIG. 1 is a schematic diagram of a display device of an embodiment of the disclosure;
FIG. 2A partial cross-section of a display device of an embodiment of the disclosure;
FIG. 2B perspective view of a tiling display device of an embodiment of the disclosure;
FIGS. 3 and 4 are cross-sectional views of a display device according to an exemplary embodiment of the present disclosure;
FIG. 5 is a schematic enlarged plan view of a display device according to another exemplary embodiment of the present disclosure;
FIG. 6 is a cross-sectional view of a display device according to another exemplary embodiment of the present disclosure;
FIGS. 7A to 7F are process diagrams for explaining a manufacturing method of a display device according to another exemplary embodiment of the present disclosure;
FIG. 8 is a view for explaining an effect according to a first connection electrode and a second connection electrode of a display device according to another exemplary embodiment of the present disclosure;
FIG. 9 is an enlarged plan view of a display device according to still another exemplary embodiment of the present disclosure;
FIG. 10 is an enlarged plan view of a display device according to still another exemplary embodiment of the present disclosure;
FIG. 11 is an enlarged plan view of a display device according to still another exemplary embodiment of the present disclosure;
FIG. 12 is an enlarged plan view of a display device according to still another exemplary embodiment of the present disclosure;
FIGS. 13A to 13C are cross-sectional views of a display device according to still another exemplary embodiment of the present disclosure; and
FIG. 14 is a cross-sectional view of a display device according to still another exemplary embodiment of the present disclosure.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION

Reference will now be made in detail to embodiments of the present disclosure, examples of which may be illustrated in the accompanying drawings. In the following description, when a detailed description of well-known functions or configurations related to this document is determined to unnecessarily cloud a gist of the inventive concept, the detailed description thereof will be omitted or briefly provided. The progression of processing steps and/or operations described is an example; however, the sequence of steps and/or operations is not limited to that set forth herein and may be changed as is known in the art, with the exception of steps and/or operations necessarily occurring in a particular order. Like reference numerals designate like elements throughout. Names of the respective elements used in the following explanations may be selected only for convenience of writing the specification and may be thus different from those used in actual products.

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure.

The shapes, sizes, areas, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted or briefly provided to avoid unnecessarily obscuring the subject matter of the present disclosure. The terms such as "including," "having," and "comprising" used herein are generally intended to allow other components to be added unless the terms are used with the term "only". Any references to singular may include plural unless expressly stated otherwise.

Components are interpreted to include an ordinary error range even if not expressly stated.

Where positional relationships are described, for example, where the positional relationship between two parts is described using "on," "over," "under," "above," "below," "beneath," "near," "close to," or "adjacent to," "beside," "next to," or the like, one or more other parts may be disposed between the two parts unless a more limiting term, such as "immediate(ly)," "direct(ly)," or "close(ly)" is used. For example, when a structure is described as being positioned "on," "over," "under," "above," "below," "beneath," "near," "close to," or "adjacent to," "beside," or "next to" another structure, this description should be construed as including a case in which the structures contact each other as well as a case in which a third structure is disposed or interposed therebetween. Furthermore, the terms "left," "right," "top," "bottom, "downward," "upward," "upper," "lower," and the like refer to an arbitrary frame of reference.

When an element or layer is disposed "on" another element or layer, another layer or another element may be interposed directly on the other element or therebetween.

Although the terms "first", "second", "A," "B," "(a)," "(b)" and the like are used for describing various components, these components are not confined by these terms. These terms are merely used for distinguishing one component from the other components. Therefore, a first component to be mentioned below may be a second component in a technical concept of the present disclosure. Also, when an element or layer is described as being "connected," "coupled," or "adhered" to another element or layer, the element or layer can not only be directly connected, or adhered to that other element or layer, but also be indirectly connected, or adhered to that other another element or layer with one or more intervening elements or layers "disposed" between the elements or layers, unless otherwise specified.

Like reference numerals generally denote like elements throughout the specification.

A size and a thickness of each component illustrated in the drawing are illustrated for convenience of description, and the present disclosure is not limited to the size and the thickness of the component illustrated.

The term "at least one" should be understood as including any and all combinations of one or more of the associated listed items. For example, the meaning of "at least one of a first element, a second element, and a third element" encompasses the combination of all three listed elements, combinations of any two of the three elements, as well as each individual element, the first element, the second element, or the third element.

The features of various embodiments of the present disclosure can be partially or entirely adhered to or combined with each other and can be interlocked and operated in technically various ways, and the embodiments can be carried out independently of or in association with each other.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" may apply, for example, to a separate circuit or structure, an integrated circuit, a computational block of a circuit device, or any structure configured to perform a described function as should be understood to one of ordinary skill in the art.

A transistor used in a display device according to exemplary embodiments of the present disclosure may be implemented as any one transistor of an n-channel transistor (NMOS) and a p-channel transistor (PMOS). The transistor may be implemented as an oxide semiconductor transistor having an oxide semiconductor as an active layer or a low temperature poly-silicon (LTPS) transistor having LTPS as the active layer. The transistor may at least include a gate electrode, a source electrode, and a drain electrode. The transistor may be implemented as a thin film transistor (TFT) on a display panel. A carrier in the transistor flows from a source electrode to a drain electrode. In the case of the n-channel transistor (NMOS), since the carrier is an electron, a source voltage may be lower than a drain voltage so that the electron may flow from the source electrode to the drain electrode. In the n-channel transistor (NMOS), a current may flow from the drain electrode to the source electrode, and the source electrode may be an output terminal. In the case of the p-channel transistor (PMOS), since the carrier is a hole, the source voltage may be higher than the drain voltage so that the hole may flow from the source electrode to the drain electrode. Since the hole flows from the source electrode to the drain electrode in the p-channel transistor (PMOS), the current may flow from a source electrode to a drain electrode, and the drain electrode may be the output terminal. Accordingly, it should be noted that since the source and the drain may be changed according to an applied voltage, the source and the drain of the transistor are not fixed. In the present disclosure, a description is made by assuming that the transistor is the n-channel transistor (NMOS), but the present disclosure is not limited thereto, but the p-channel transistor may be used, and as a result, a circuit configuration may also be changed.

A gate signal of the transistor used as switch elements may swing between a gate on voltage and a gate off voltage. The gate on voltage may be set to a voltage higher than a threshold voltage Vth of the transistor, and the gate off voltage may be set to a voltage lower than the threshold voltage Vth of the transistor. The transistor is turned on in response to the gate on voltage, while turned off in response to the gate off voltage. In the case of the n-channel transistor (NMOS), the gate on voltage may be a gate high voltage (VGH), and the gate off voltage may be a gate low voltage (VGL). In the case of the p-channel transistor (PMOS), the gate on voltage may be the gate low voltage (VGL), and the gate off voltage may be the gate high voltage (VGH).

Hereinafter, a display device according to exemplary embodiments of the present disclosure will be described in detail with reference to accompanying drawings.

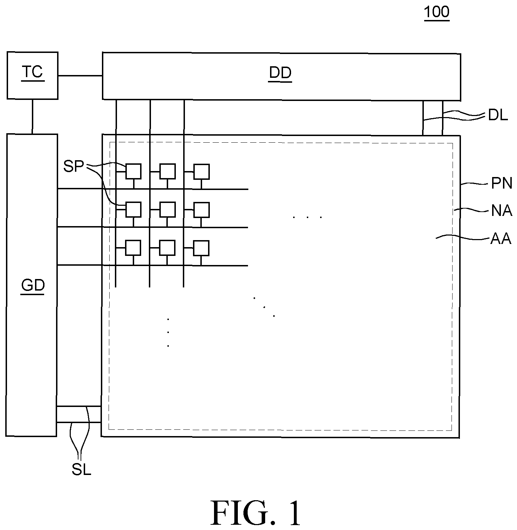

FIG. 1 is a schematic diagram of a display device according to an exemplary embodiment of the present disclosure. In FIG. 1, for the convenience of description, among various components of the display device 100, a display panel PN, a gate driver GD, a data driver DD, and a timing controller TC are illustrated.

Referring to FIG. 1, the display device 100 includes a display panel PN including a plurality of sub pixels SP, a gate driver GD and a data driver DD which supply various signals to the display panel PN, and a timing controller TC which controls the gate driver GD and the data driver DD.

The gate driver GD supplies a plurality of scan signals to a plurality of scan lines SL according to a plurality of gate control signals supplied from the timing controller TC. Even though in FIG. 1, it is illustrated that one gate driver GD is disposed to be spaced apart from one side of the display panel PN, the number of the gate drivers GD and the placement thereof are not limited thereto. For example, the gate driver GD may be disposed at one or two sides of the display panel PN in Gate in Panel (GIP) manner, or may be disposed within the display area of the display panel PN in a gate-in-active area (GIA) manner, and the present disclosure is not limited thereto.

The data driver DD converts image data input from the timing controller TC into a data voltage using a reference gamma voltage in accordance with a plurality of data control signals supplied from the timing controller TC. The data driver DD may supply the converted data voltage to the plurality of data lines DL.

The timing controller TC aligns image data input from the outside to supply the image data to the data driver DD. The timing controller TC may generate a gate control signal and a data control signal using synchronization signals input from the outside, such as a dot clock signal, a data enable signal, and horizontal/vertical synchronization signals. The timing controller TC supplies the generated gate control signal and data control signal to the gate driver GD and the data driver DD, respectively, to control the gate driver GD and the data driver DD.

The display panel PN is a configuration which displays images to the user and includes the plurality of sub pixels SP. In the display panel PN, the plurality of scan lines SL and the plurality of data lines DL intersect each other and the plurality of sub pixels SP is connected to the scan lines SL and the data lines DL, respectively. In addition, even though it is not illustrated in the drawing, each of the plurality of sub pixels SP may be connected to a high potential power line, a low potential power line, a reference line, and the like.

In the display panel PN, an active area AA and a non-active area NA enclosing the active area AA may be defined.

The active area AA is an area in which images are displayed in the display device 100. In the active area AA, a plurality of sub pixels SP which configure a plurality of pixels PX and a circuit for driving the plurality of sub pixels SP may be disposed. The plurality of sub pixels SP are a minimum unit which configures the active area AA and n sub pixels SP may form one pixel PX. In each of the plurality of sub pixels SP, a light emitting diode and a thin film transistor for driving the light emitting diode may be disposed. The plurality of light emitting diodes may be defined in different manners depending on the type of the display panel PN. For example, when the display panel PN is an inorganic light emitting display panel, the light emitting diode may be a light emitting diode (LED) or a micro light emitting diode (micro-LED) which may have a size less than 100 micrometers, but is not limited thereto.

In the active area AA, a plurality of signal lines which transmit various signals to the plurality of sub pixels SP are disposed. For example, the plurality of signal lines may include a plurality of data lines DL which supply a data voltage to each of the plurality of sub pixels SP and a plurality of scan lines SL which supply a gate voltage to each of the plurality of sub pixels SP. The plurality of scan lines SL extend to one direction in the active area AA to be connected to the plurality of sub pixels SP and the plurality of data lines DL extend to a direction different from the one direction in which the scan lines extend in the active area AA to be connected to the plurality of sub pixels SP. In addition, in the active area AA, a low potential power line and a high potential power line may be further disposed, but are not limited thereto.

The non-active area NA is an area where images are not displayed so that the non-active area NA may be defined as an area extending from the active area AA or an area adjacent to the active area AA. In the non-active area NA, a link line which transmits a signal to the sub pixel SP of the active area AA, a pad electrode, or a driving IC, such as a gate driver IC or a data driver IC, may be disposed. The non-active area NA may be located on a rear surface of the display panel PN, for example, a surface on which the sub pixels SP are not disposed or may be omitted, and is not limited as illustrated in the drawing.

In addition, a driver, such as a gate driver GD, a data driver DD, and a timing controller TC, may be connected to the display panel PN in various ways. For example, the gate driver GD may be mounted in the non-active area NA in a gate in panel (GIP) manner or mounted between the plurality of sub pixels SP in the active area AA in a gate in active area (GIA) manner. For example, the data driver DD and the timing controller TC are formed in separate flexible film and printed circuit board and may be electrically connected to the display panel PN by bonding the flexible film and the printed circuit board to a pad electrode formed in the non-active area NA of the display panel PN. If the gate driver GD is mounted in the GIP manner and the data driver DD and the timing controller TC transmit a signal to the display panel PN through a pad electrode of the non-active area NA, an area of the non-active area NA to dispose the gate driver GD and the pad electrode needs to be ensured. In this case, a bezel may be increased.

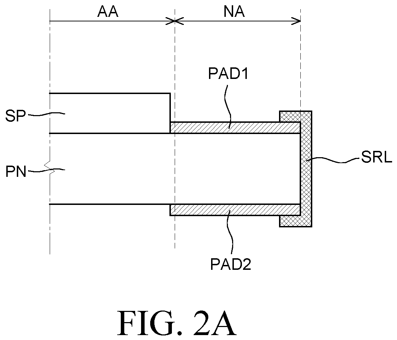

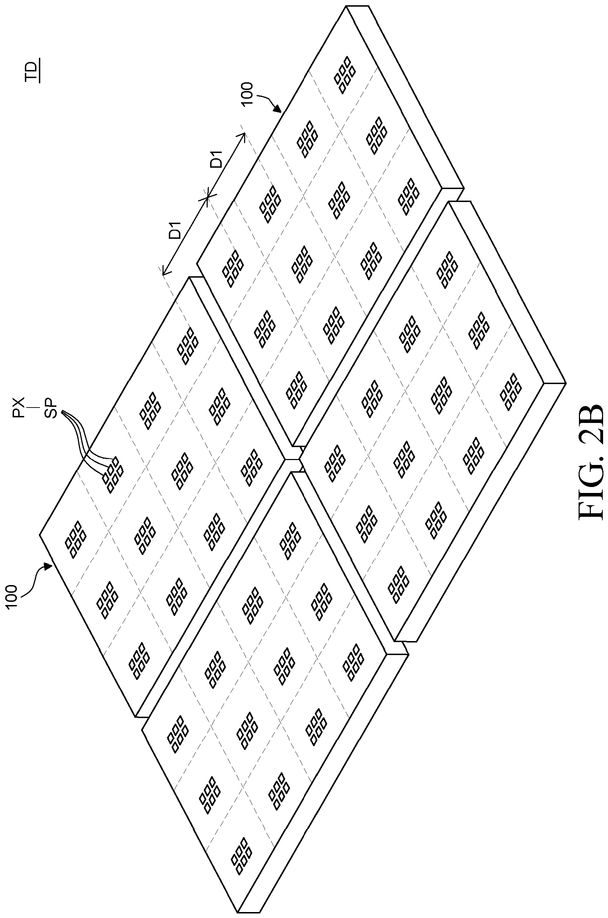

In contrast, when the gate driver GD is mounted in the active area AA in the GIA manner and a side line SRL connects the signal line on the front surface of the display panel PN to the pad electrode on a rear surface of the display panel PN which is formed to bond the flexible film and the printed circuit board onto a rear surface of the display panel PN, the non-active area NA may be minimized or reduced on the front surface of the display panel PN. For example, when the gate driver GD, the data driver DD, and the timing controller TC are connected to the display panel PN as described above, a zero bezel in which there is no bezel may be substantially implemented, which will be described in more detail with reference to FIGS. 2A and 2B.

FIG. 2A is a partial cross-sectional view of a display device according to an exemplary embodiment of the present disclosure and FIG. 2B is a perspective view of a tiling display device according to an exemplary embodiment of the present disclosure.

In the non-active area NA of the display panel PN, a plurality of pad electrodes for transmitting various signals to the plurality of sub pixels SP are disposed. For example, in a non-active area NA on the front surface of the display panel PN, a first pad electrode PAD 1 which transmits a signal to the plurality of sub pixels SP is disposed. In a non-active area NA on the rear surface of the display panel PN, a second pad electrode PAD2 which is electrically connected to a driving component, such as a flexible film and the printed circuit board, is disposed.

For example, the display panel PN may be formed by bonding two or more substrates in a vertical direction. At this time, the first pad electrode PAD1 and the second pad electrode PAD2 may be disposed on different substrates. For example, the first pad electrode PAD1 may be disposed on a front surface of an upper substrate. The second pad electrode PAD2 may be disposed on a rear surface of a lower substrate. For example, the display panel PN may be formed by bonding the upper substrate with the first pad electrode PAD1 disposed on the front surface and the lower substrate with the second pad electrode PAD2 disposed on the rear surface, but is not limited thereto.

In this case, even though it is not illustrated in the drawing, various signal lines connected to the plurality of sub pixels SP, for example, a scan line SL or a data line DL extends from the active area AA to the non-active area NA to be electrically connected to the first pad electrode PAD1.

The side line SRL is disposed along a side surface of the display panel PN. The side line SRL may electrically connect the first pad electrode PAD 1 on the front surface of the display panel PN and the second pad electrode PAD2 on the rear surface of the display panel PN. Therefore, a signal from a driving component on the rear surface of the display panel PN may be transmitted to the plurality of sub pixels SP through the second pad electrode PAD2, the side line SRL, and the first pad electrode PAD1. Accordingly, a signal transmitting path is formed from the front surface of the display panel PN to the side surface and the rear surface to minimize or reduce an area of the non-active area NA of the display panel PN.

Referring to FIG. 2B, a tiling display device TD having a large screen size may be implemented by connecting or combining a plurality of display devices 100. At this time, as illustrated in FIG. 2A, when the tiling display device TD is implemented using a display device 100 with a minimized or reduced bezel, a seam area in which an image between the display devices 100 is not displayed is minimized or reduced so that a display quality may be improved.

For example, the plurality of sub pixels SP may form one pixel PX and a distance D1 between an outermost pixel PX of one display device 100 and an outermost pixel PX of another display device 100 adjacent to the one display device may be implemented to be equal to a distance D1 between pixels PX in one display device 100. Accordingly, the constant interval of the pixels PX between the display devices 100 is implemented so as to minimize or reduce the seam area.

However, FIGS. 2A and 2B are illustrative so that the display device 100 according to the exemplary embodiment of the present disclosure may be a general display device with a bezel, but is not limited thereto.

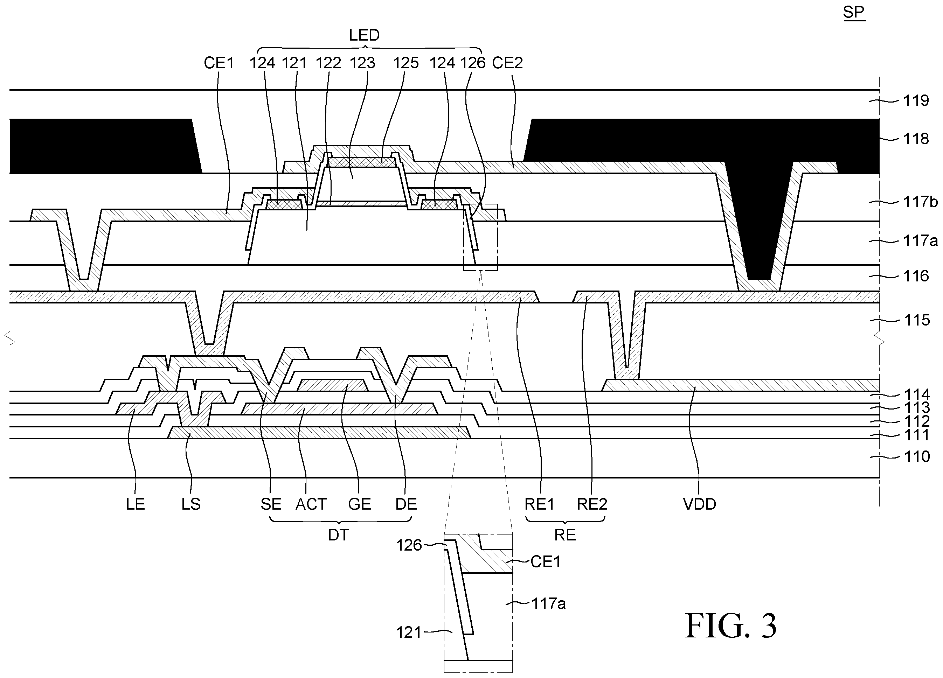

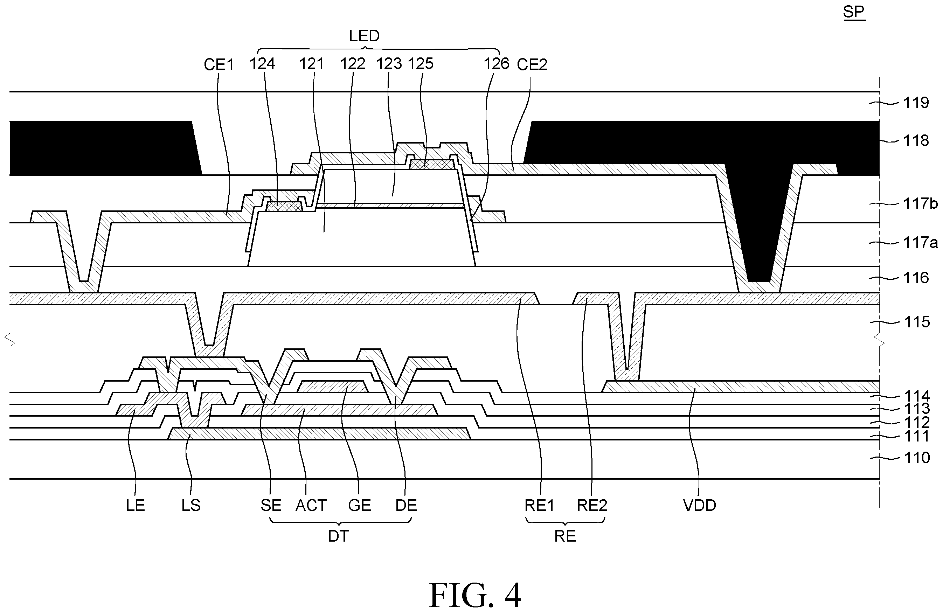

FIGS. 3 and 4 are cross-sectional views of a display device according to an exemplary embodiment of the present disclosure. For example, FIGS. 3 and 4 are cross-sectional views of one sub pixel SP.

Referring to FIGS. 3 and 4, in each of the plurality of sub pixels SP of the display panel PN of the display device 100 according to the exemplary embodiment of the present disclosure, a substrate 110, a buffer layer 111, a gate insulating layer 112, a first interlayer insulating layer 113, a second interlayer insulating layer 114, an over coating layer 115, an adhesive layer 116, a first planarization layer 117a, a second planarization layer 117b, a bank 118, a third planarization layer 119, a driving transistor DT, a light emitting diode LED, a plurality of reflective electrodes RE, a light shielding layer LS, an auxiliary electrode LE, a plurality of first connection electrodes CE1, and a plurality of second connection electrodes CE2 may be disposed.

First, the substrate 110 is a component for supporting various components included in the display device 100 and may be formed of an insulating material. For example, the substrate 110 may be formed of glass or resin. Further, the substrate 110 may be configured to include a polymer or plastics or may be formed of a material having flexibility. For another example, the substrate 110 may include glass, plastic, or a flexible polymer film. For example, the flexible polymer film may be made of any one of polyethylene terephthalate(PET), polycarbonate(PC), acrylonitrile-butadiene-styrene copolymer(ABS), polymethyl methacrylate(PMMA), polyethylene naphthalate(PEN), polyether sulfone(PES), cyclic olefin copolymer(COC), triacetylcellulose(TAC) film, polyvinyl alcohol(PVA) film, polyimide(PI) film, and polystyrene(PS), which is only an example and is not necessarily limited thereto.

The light shielding layer LS may be disposed in each of the plurality of sub pixels SP on the substrate 110. The light shielding layer LS blocks light incident onto an active layer ACT of the driving transistor DT to be described below from a lower portion of the substrate 110. Light which is incident onto the active layer ACT of the driving transistor DT is blocked by the light shielding layer LS to minimize or reduce a leakage current.

The buffer layer 111 may be disposed on the substrate 110 and the light shielding layer LS. The buffer layer 111 may reduce permeation of moisture or impurities through the substrate 110. The buffer layer 111 may be configured by a single layer or a double layer of silicon oxide (SiOx) or silicon nitride (SiNx), but is not limited thereto. However, the buffer layer 111 may be omitted depending on a type of substrate 110 or a type of transistor, but is not limited thereto.

The driving transistor DT may be disposed on the buffer layer 111. The driving transistor DT includes an active layer ACT, a gate electrode GE, a source electrode SE, and a drain electrode DE.

The active layer ACT may be disposed on the buffer layer 111. The active layer ACT may be formed of a semiconductor material, such as an oxide semiconductor, amorphous silicon, or polysilicon, but is not limited thereto. The oxide semiconductor may be made of a metal oxide such as zinc (Zn), indium (In), gallium (Ga), tin (Sn), and titanium (Ti) or a combination of a metal such as zinc (Zn), indium (In), gallium (Ga), tin (Sn), or titanium (Ti) and its oxide. Specifically, the oxide semiconductor may include zinc oxide (ZnO), zinc-tin oxide (ZTO), zinc-indium oxide (ZIO), indium oxide (InO), titanium oxide (TiO), indium-gallium-zinc oxide (IGZO), indium-zinc-tin oxide (IZTO) , indium zinc oxide (IZO), indium gallium tin oxide (IGTO), and indium gallium oxide (IGO), but is not limited thereto.

The gate insulating layer 112 may be disposed on the active layer ACT. The gate insulating layer 112 is an insulating layer which insulates the active layer ACT from the gate electrode GE and may be configured by a single layer or a double layer of silicon oxide (SiOx) or silicon nitride (SiNx), but is not limited thereto.

The gate electrode GE may be disposed on the gate insulating layer 112. The gate electrode GE may be configured by a conductive material, such as copper (Cu), aluminum (Al), molybdenum (Mo), nickel (Ni), titanium (Ti), chrome (Cr), or an alloy thereof, but is not limited thereto.

A first interlayer insulating layer 113 and a second interlayer insulating layer 114 may be disposed on the gate electrode GE. In the first interlayer insulating layer 113 and the second interlayer insulating layer 114, a contact hole through which the source electrode SE and the drain electrode DE are connected to the active layer ACT is formed. The first interlayer insulating layer 113 and the second interlayer insulating layer 114 are insulating layers for protecting a component below the first interlayer insulating layer 113 and the second interlayer insulating layer 114 and may be configured by a single layer or a double layer of silicon oxide (SiOx) or silicon nitride (SiNx), but are not limited thereto.

The source electrode SE and the drain electrode DE which are electrically connected to the active layer ACT may be disposed on the second interlayer insulating layer 114. The source electrode SE and the drain electrode DE may be configured by a conductive material, such as copper (Cu), aluminum (Al), molybdenum (Mo), nickel (Ni), titanium (Ti), chrome (Cr), or an alloy thereof, but are not limited thereto.

In addition, in the present disclosure, it is described that the first interlayer insulating layer 113 and the second interlayer insulating layer 114, for example, a plurality of insulating layers is disposed between the gate electrode GE and the source electrode SE and the drain electrode DE. However, only one insulating layer may be disposed between the gate electrode GE and the source electrode SE and the drain electrode DE, but is not limited thereto.

As illustrated in the drawings, when a plurality of insulating layers, such as the first interlayer insulating layer 113 and the second interlayer insulating layer 114, are disposed between the gate electrode GE and the source electrode SE and the drain electrode DE, an electrode may be further formed between the first interlayer insulating layer 113 and the second interlayer insulating layer 114. The additionally formed electrode may form a capacitor with the other configuration disposed below the first interlayer insulating layer 113 or above the second interlayer insulating layer 114.

The auxiliary electrode LE may be disposed on the gate insulating layer 112. The auxiliary electrode LE is an electrode which electrically connects the light shielding layer LS below the buffer layer 111 to any one of the source electrode SE and the drain electrode DE on the second interlayer insulating layer 114. For example, the light shielding layer LS is electrically connected to any one of the source electrode SE or the drain electrode DE through the auxiliary electrode LE so as not to operate as a floating gate. Therefore, fluctuation of a threshold voltage of the driving transistor DT caused by the floated light shielding layer LS may be minimized or reduced. Even though in the drawing, it is illustrated that the light shielding layer LS is connected to the source electrode SE, the light shielding layer LS may also be connected to the drain electrode DE, but is not limited thereto.

A power line VDD may be disposed on the second interlayer insulating layer 114. The power line VDD is electrically connected to the light emitting diode LED together with the driving transistor DT to allow the light emitting diode LED to emit light. The power line VDD may be configured by a conductive material such as copper (Cu), aluminum (Al), molybdenum (Mo), nickel (Ni), titanium (Ti), chrome (Cr), or an alloy thereof, but is not limited thereto. It is to be noted that although the power line is shown as a high-potential power line VDD in some embodiments of the present disclosure, but the present disclosure is not limited thereto, and the power line electrically connected to the light emitting diode LED may also be a low-potential power line VSS.

The over coating layer 115 is disposed on the driving transistor DT and the power line VDD. The over coating layer 115 may planarize an upper portion of the substrate 110 on which the driving transistor DT is disposed. The over coating layer 115 may be configured by a single layer or a double layer, and for example, may be formed of a photoresist or an acrylic organic material, but is not limited thereto.

The plurality of reflective electrodes RE which are spaced apart from each other may be disposed on the over coating layer 115. The plurality of reflective electrodes RE may electrically connect the light emitting diode LED to the power line VDD and the driving transistor DT and may serve as a reflector which reflects light emitted from the light emitting diode LED to the upper portion of the light emitting diode LED. The plurality of reflective electrodes RE are formed of a conductive material having the excellent reflecting property to reflect light emitted from the light emitting diode LED toward the upper portion of the light emitting diode LED.

The plurality of reflective electrodes RE may include a first reflective electrode RE1 and a second reflective electrode RE2. The first reflective electrode RE1 may electrically connect the driving transistor DT and the light emitting diode LED. The first reflective electrode RE1 may be connected to the source electrode SE or the drain electrode DE of the driving transistor DT through a contact hole formed in the over coating layer 115. The first reflective electrode RE1 may be electrically connected to the first electrode 124 of the light emitting diode LED through a first connection electrode CE1.

The second reflective electrode RE2 may electrically connect the power line VDD and the light emitting diode LED. The second reflective electrode RE2 may be connected to the power line VDD through a contact hole formed in the over coating layer 115 and may be electrically connected to the second electrode 125 of the light emitting diode LED through a second connection electrode CE2 to be described below.

The adhesive layer 116 is formed on the front surface of the substrate 110 on the plurality of reflective electrodes RE to fix the light emitting diodes LED disposed on the adhesive layer 116. The adhesive layer 116 may be formed of a photo curable adhesive material which is cured by light. For example, the adhesive layer 116 may be formed of an acrylic material including a photoresist, but is not limited thereto.

The plurality of light emitting diodes LED may be disposed in each of the plurality of sub pixels SP on the adhesive layer 116. The plurality of light emitting diodes LED is elements which emit light by a current and may include light emitting diodes LED which emit red light, green light, and blue light and implement various colored light including white by a combination thereof. For example, the plurality of light emitting diodes LED may be light emitting diodes (LED) or micro-LEDs, but is not limited thereto. In the present disclosure, the light emitting diodes LED may also be referred to as light emitting elements or light emitting device, but is not limited thereto.

The light emitting diode LED may include a first semiconductor layer 121, an emission layer 122, a second semiconductor layer 123, a first electrode 124, a second electrode 125, and a passivation film 126.

The first semiconductor layer 121 may be disposed on the adhesive layer 116 and the second semiconductor layer 123 may be disposed on the first semiconductor layer 121. The first semiconductor layer 121 and the second semiconductor layer 123 may be layers formed by doping n-type and p-type impurities into a specific material. For example, the first semiconductor layer 121 and the second semiconductor layer 123 may be layers doped with n-type and p-type impurities into a material such as gallium nitride (GaN), indium aluminum phosphide (InAlP), or gallium arsenide (GaAs), respectively. The p-type impurity may be magnesium (Mg), zinc (Zn), and beryllium (Be), and the n-type impurity may be silicon (Si), germanium, and tin (Sn), but is not limited thereto.

A part of the first semiconductor layer 121 may be disposed to outwardly protrude from the second semiconductor layer 123. A top surface of the first semiconductor layer 121 may be formed by a part overlapping a bottom surface of the second semiconductor layer 123 and a part disposed at an outside of the bottom surface of the second semiconductor layer 123. The light emitting diode LED may be a lateral light emitting diode LED. However, sizes and shapes of the first semiconductor layer 121 and the second semiconductor layer 123 may be modified in various forms, but are not limited thereto. In the present disclosure, a top surface of an element may also be referred to as an upper surface of such element, and a bottom surface of an element may also be referred to as a lower surface of such element, vice versa.

For example, referring to FIG. 3, the second semiconductor layer 123 is disposed in the middle of an upper surface (e.g., a top surface) of the first semiconductor layer 121 so that the entire second semiconductor layer 123 may overlap the first semiconductor layer 121. The second semiconductor layer 123 is disposed inside the first semiconductor layer 121 and an edge of the second semiconductor layer 123 may be disposed in the inside from the edge of the first semiconductor layer 121. The first semiconductor layer 121 may protrude to the outside of the second semiconductor layer 123 from the entire edge of the second semiconductor layer 123. The first semiconductor layer 121 may outwardly protrude from the second semiconductor layer 123 in all directions.

Referring to FIG. 4, the first semiconductor layer 121 may protrude outwardly from the second semiconductor layer 123 in some direction. The first semiconductor layer 121 may protrude to the outside of the second semiconductor layer 123 from a part of the edge of the second semiconductor layer 123. A part of the first semiconductor layer 121 may protrude outwardly from the second semiconductor layer 123 in a specific direction.

The emission layer 122 may be disposed between the first semiconductor layer 121 and the second semiconductor layer 123. The emission layer 122 is supplied with holes and electrons from the first semiconductor layer 121 and the second semiconductor layer 123 to emit light.

The emission layer 122 may be formed by a single layer or a multi-quantum well (MQW) structure, and for example, may be formed of indium gallium nitride (InGaN) or gallium nitride (GaN), but is not limited thereto.

The first electrode 124 may be disposed on the first semiconductor layer 121. The first electrode 124 is an electrode which electrically connects the driving transistor DT and the first semiconductor layer 121. In this case, the first semiconductor layer 121 is a semiconductor layer doped with an n-type impurity and the first electrode 124 may be a cathode. The first electrode 124 may be disposed on a top surface of the first semiconductor layer 121 which is exposed from the emission layer 122 and the second semiconductor layer 123. For example, the first electrode 124 is disposed along a periphery of a top surface of the first semiconductor layer 121 and may have a ring shape in the plan view. The first electrode 124 may be configured by a conductive material, for example, a transparent conductive material, such as indium tin oxide (ITO) or indium zinc oxide (IZO) or an opaque conductive material, such as titanium (Ti), gold (Au), silver (Ag), copper (Cu) or an alloy thereof, but is not limited thereto.

The second electrode 125 may be disposed on the second semiconductor layer 123. The second electrode 125 may be disposed on the top surface of the second semiconductor layer 123. At this time, the second semiconductor layer 123 is disposed on the first semiconductor layer 121 so that the second electrode 125 disposed on the top surface of the second semiconductor layer 123 may be disposed to be higher than the first electrode 124 disposed on the top surface of the first semiconductor layer 121. The second electrode 125 is an electrode which electrically connects the power line VDD and the second semiconductor layer 123. In this case, the second semiconductor layer 123 is a semiconductor layer doped with a p-type impurity and the second electrode 125 may be an anode. The second electrode 125 may be configured by a conductive material, for example, a transparent conductive material, such as indium tin oxide (ITO) or indium zinc oxide (IZO) or an opaque conductive material, such as titanium (Ti), gold (Au), silver (Ag), copper (Cu) or an alloy thereof, but is not limited thereto.

Next, the passivation film 126 which encloses the first semiconductor layer 121, the emission layer 122, the second semiconductor layer 123, the first electrode 124, and the second electrode 125 may be disposed. The passivation film 126 is formed of an insulating material to protect the first semiconductor layer 121, the emission layer 122, and the second semiconductor layer 123. In the passivation film 126, a contact hole which exposes the first electrode 124 and the second electrode 125 is formed to electrically connect the first connection electrode CE1 and the second connection electrode CE2 to the first electrode 124 and the second electrode 125 which will be formed later, respectively.

In addition, in the display device 100 according to the exemplary embodiment of the present disclosure, the light emitting didoes LED disposed in different sub pixels SP are configured with different shapes, respectively, to distinguish the plurality of light emitting diodes LED. Therefore, when the light emitting diode LED is self-assembled, the plurality of light emitting diodes LED is formed to have different shapes to be self-assembled in a position corresponding to each of the plurality of sub pixels SP.

In addition, the present disclosure is not limited thereto and the light emitting diodes LED may have the same size or shape. For example, the light emitting diode LED is transferred onto a separate transferring substrate, rather than a self-assembling method, to be disposed in positions corresponding to the plurality of sub pixels SP.

The first planarization layer 117a may be disposed on the adhesive layer 116. The first planarization layer 117a is disposed so as to enclose a part of side surfaces of the plurality of light emitting diodes LED to fix and protect the plurality of light emitting diodes LED.

For example, the first planarization layer 117a may be disposed so as to enclose the passivation film 126 disposed on a lower edge of the light emitting diode LED. Therefore, the short defect of the first connection electrode CE1 due to the torn passivation film 126 may be suppressed. For example, during a process of separating a wafer and the light emitting diode LED, a part of the passivation film 126 may be torn on the lower edge of the light emitting diode LED. Therefore, the passivation film 126 may expose a part of the first semiconductor layer 121 of the lower edge of the light emitting diode LED. Accordingly, a step may be caused in the lower edge of the light emitting diode LED by the torn passivation film 126. At this time, when the first connection electrode CE1 is disposed so as to enclose the side surface of the passivation film 126, the first connection electrode CE1 may be shorted by the step caused by the torn passivation film 126.

Accordingly, before placing the first connection electrode CE1, the first planarization layer 117a is disposed so as to enclose the lower edge of the light emitting diode LED so that the lower edge of the light emitting diode LED may be spaced apart from the first connection electrode CE1. Therefore, even though an under-cut (UC) structure caused by the torn passivation film 126 is formed on the lower edge of the light emitting diode LED, the first planarization layer 117a is in contact with at least a part of the side surface of the light emitting diode LED to be filled in the under-cut (UC) structure. Therefore, the short defect of the first connection electrode CE1 due to the under-cut (UC) structure may be minimized or reduced.

The first planarization layer 117a may be configured by a single layer or a double layer, and for example, may be formed of a photoresist or an acrylic organic material, but is not limited thereto.

In addition, the first planarization layer 117a may be lower than a height of the first electrode 124. For example, the thickness of the first planarization layer 117a may be adjusted by performing the ashing process. For example, after applying a material layer of the first planarization layer 117a so as to cover the light emitting diode LED, the ashing process is performed to reduce the overall thickness of the material layer of the first planarization layer 117a to form the height of the first planarization layer 117a to be lower than the height of the first electrode 124, but the present disclosure is not limited thereto. For example, the first planarization layer 117a may have a height lower than or equal to a height of the first electrode 124, as long as the first electrode 124 is exposed by the first planarization layer 117a. Therefore, the first planarization layer 117a may expose the first electrode 124. Accordingly, the first connection electrode CE1 disposed on the first planarization layer 117a may be easily connected to the first electrode 124 without a separate contact hole.

The first connection electrode CE1 may be disposed on the first planarization layer 117a. The first connection electrode CE1 is an electrode which is disposed in each of the plurality of sub pixels SP to electrically connect the light emitting diode LED and the driving transistor DT. The first connection electrode CE1 may be connected to the first reflective electrode RE1 through the contact hole formed in the first planarization layer 117a and the adhesive layer 116. Accordingly, the first connection electrode CE1 may be electrically connected to any one of the source electrode SE and the drain electrode DE of the driving transistor DT through the first reflective electrode RE1. For example, the first connection electrode CE1 may connect the first electrode 124 of the light emitting diode LED to the source electrode SE of the driving transistor DT, but it is not limited thereto.

In addition, the first connection electrode CE1 may be formed by placing a material layer of the first connection electrode CE1 so as to cover the light emitting diode LED and then partially removing such material layer disposed on a part of a side surface and a top surface of the second semiconductor layer 123 and the material layer of the first connection electrode CE1 disposed on the second electrode 125. For example, after applying a photoresist on the light emitting diode LED, the photoresist applied on the top surface of the second electrode 125 and the top surface and a part of the side surface of the second semiconductor layer 123 is removed to expose the second electrode 125. Therefore, only a part of the material layer of the first connection electrode CE1 which is disposed on the top surface of the second electrode 125 and a part of the side surface and the top surface of the second semiconductor layer 123 may be exposed. Further, the exposed material layer of the first connection electrode CE1 is removed by the ashing process to form the first connection electrode CE1, but it is not limited thereto.

The second planarization layer 117b may be disposed on the first planarization layer 117a and the plurality of first connection electrodes CE1. The second planarization layer 117b planarizes an upper portion of the substrate 110 in which the light emitting diode LED is disposed together with the first planarization layer 117a and may fix the light emitting diode LED onto the substrate 110 together with the adhesive layer 116.

Further, the second planarization layer 117b is disposed so as to cover the first connection electrode CE1 to separate the first connection electrode CE1 from the second connection electrode CE2. Therefore, the short defect of the first connection electrode CE1 and the second connection electrode CE2 may be suppressed.

For example, only the second planarization layer 117b may be disposed between the first connection electrode CE1 and the second connection electrode CE2. The second planarization layer 117b may be configured by a single layer and for example, may be formed of a photoresist or an acrylic organic material, but is not limited thereto.

The second connection electrode CE2 may be disposed on the second planarization layer 117b. The second connection electrode CE2 is an electrode for electrically connecting the light emitting diode LED and the power line VDD. The second connection electrode CE2 may be connected to the second reflective electrode RE2 through the contact holes formed in the second planarization layer 117b, the first planarization layer 117a, and the adhesive layer 116. Accordingly, the second connection electrode CE2 may be electrically connected to the power line VDD through the second reflective electrode RE2. For example, the second connection electrode CE2 may connect the second electrode 125 of the light emitting diode LED to the power line VDD, but it is not limited thereto.

The bank 118 may be disposed on the second planarization layer 117b and the second connection electrode CE2. The bank 118 is disposed so as not to overlap the light emitting diode LED to define an emission area. For example, the bank 118 covers an edge of the second connection electrode CE2 which is connected to each of the light emitting diodes LED to define the emission area. For example, the bank 118 may divide the plurality of sub pixels SP. The bank 118 may be formed of an insulating material to insulate the second connection electrodes CE2 of adjacent sub pixels SP from each other. Further, the bank 118 may include a black component having high light absorptivity or may be configured by a black bank to suppress color mixture between adjacent sub pixels SP. For example, the bank 118 may be formed of a polyimide resin, an acrylic resin, or a benzocyclobutene (BCB) resin, but is not limited thereto.

The third planarization layer 119 may be disposed on the second planarization layer 117b and the bank 118. The third planarization layer 119 is disposed so as to cover the top surface of the light emitting diode LED to planarize the upper portion of the substrate 110 on which the light emitting diode LED is disposed and fix and protect the light emitting diode LED. The third planarization layer 119 may be configured by a single layer or a double layer, and for example, may be formed of a photoresist or an acrylic organic material, but is not limited thereto.

For example, when the display device is manufactured, the light emitting diode is grown on the wafer and then is separated from the wafer to be transferred onto the adhesive layer. At this time, during the process of separating the wafer and the light emitting diode, a part of the lower edge of the light emitting diode may be torn. For example, when the light emitting diode is separated from the wafer, a part of the lower edge of the passivation film of the light emitting diode may be torn such as a part of the semiconductor layer may be exposed. Therefore, a step may be generated in the vicinity of a torn area of the passivation film. At this time, when the first connection electrode is directly formed so as to enclose the side surface of the passivation film, a short defect of the first connection electrode with the exposed semiconductor layer may be caused due to the step in the vicinity of the torn area of the passivation film.

In addition, during a process of placing or transferring the plurality of light emitting diodes on the substrate, some light emitting diodes may be erroneously aligned or erroneously disposed. At this time, when the subsequent process proceeds in the state in which some light emitting diodes are erroneously aligned or erroneously disposed, a short defect between the electrodes may occur.

For example, when the light emitting diode is erroneously aligned so that the same electrode is connected to the first electrode and the second electrode of the light emitting diode or electrodes connected to the first electrode and the second electrode of the light emitting diode are not separately disposed to overlap to cause the short defect, the light emitting diode may not normally emit light.

In the display device 100 according to the exemplary embodiment of the present disclosure, the first connection electrode CE1 connected to the first electrode 124 of the light emitting diode LED may be disposed on the first planarization layer 117a. For example, before placing the first connection electrode CE1, the first planarization layer 117a may be disposed. The first planarization layer 117a may be disposed so as to enclose a part of the side surface of the light emitting diode LED, for example, the lower edge part. Therefore, even though during the processing process, the passivation film 126 in the lower edge part of the light emitting diode LED is torn to cause the step within a nearby area, the first planarization layer 117a may be filled in the torn area of the passivation film 126. For example, the first planarization layer 117a is disposed so as to enclose the lower edge part of the light emitting diode LED to separate the first connection electrode CE1 and the torn area of the passivation film 126. Accordingly, the first planarization layer 117a is in contact with the torn area of the passivation film 126 to minimize or reduce the short defect caused by the step between the torn area of the passivation film 126 and a peripheral area.

Further, in the display device 100 according to the exemplary embodiment of the present disclosure, the first connection electrode CE1 and the first electrode 124 of the light emitting diode LED are self-aligned to be connected. For example, the material layer of the first planarization layer 117a may be disposed so as to enclose the light emitting diode LED. Next, the material layer of the first planarization layer 117a is subject to the ashing process to expose the first electrode 124. Next, the material layer of the first connection electrode CE1 may be disposed on the first planarization layer 117a. At this time, the photoresist is applied on the material layer of the first connection electrode CE1 and the photoresist may be removed by the ashing process until the second electrode 125 of the light emitting diode LED is exposed. Next, the material layer of the first connection electrode CE1 exposed by the ashing process is removed so that only the material layer of the first connection electrode CE1 disposed on the first electrode 124 and the first planarization layer 117a remains to form the first connection electrode CE1. Therefore, the first connection electrode CE1 and the first electrode 124 may be self-aligned by the ashing process of the first planarization layer 117a and the photoresist without precisely aligning the positions of the first electrode 124 and the first connection electrode CE1. Accordingly, the short defect according to the process error may be minimized or reduced.

Further, in the display device 100 according to the exemplary embodiment of the present disclosure, the second connection electrode CE2 and the second semiconductor layer 123 of the light emitting diode LED are self-aligned to be connected. For example, the ashing process is performed on the second planarization layer 117b which covers the second semiconductor layer 123 and the second electrode 125 of the light emitting diode LED to expose only the second semiconductor layer 123 and the second electrode 125 of the light emitting diode LED. In this case, even though the second connection electrode CE2 is formed by forming and patterning the material layer of the second connection electrode CE2 on the front surface of the substrate 110 including the second planarization layer 117b, the second connection electrode CE2 is in contact with only the top surface of the second electrode 125 exposed from the second planarization layer 117b. Further, the second connection electrode CE2 may be spaced apart from the first connection electrode CE1, the emission layer 122, and the first semiconductor layer 121 disposed below the second planarization layer 117b. Accordingly, the second connection electrode CE2 is in contact with only the top surface of the second electrode 125. Therefore, there is no need to ensure a process margin in consideration of positions of the first semiconductor layer 121 and the first connection electrode CE1 during the formation of the second connection electrode CE2. Therefore, the second connection electrode CE2 and the first electrode 124 may be self-aligned by the ashing process of the second planarization layer 117b without precisely aligning the positions of the second electrode 125 and the second connection electrode CE2. Therefore, the short defect of the first connection electrode CE1 and the second connection electrode CE2 according to the process error may be minimized or reduced.

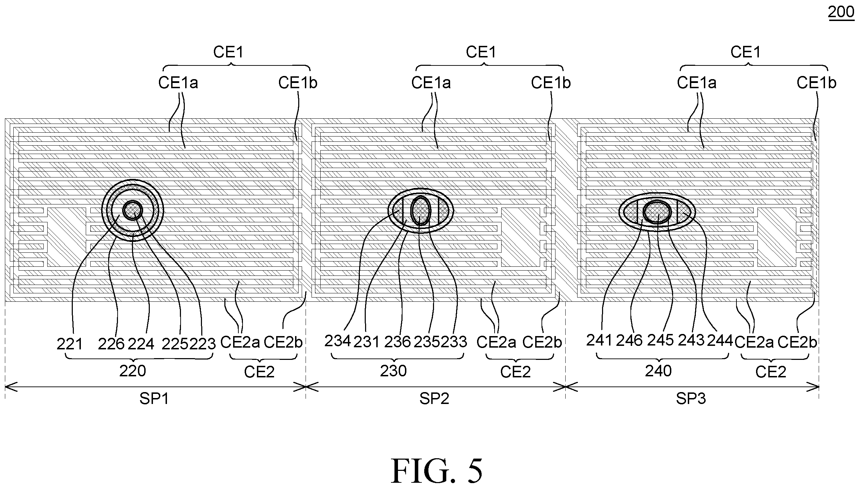

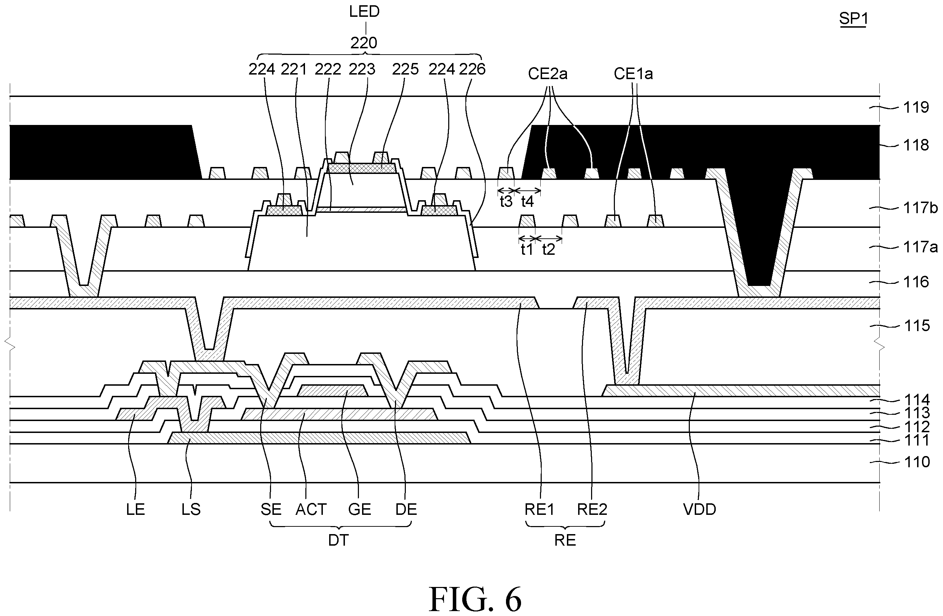

FIG. 5 is a schematic enlarged plan view of a display device according to another exemplary embodiment of the present disclosure. FIG. 6 is a cross-sectional view of a display device according to another exemplary embodiment of the present disclosure. In FIG. 5, the light emitting element LED, the first connection electrode CE1, and the second connection electrode CE2, among various configurations of the display device, are illustrated. Due to the actual structure, the first connection electrode CE1 and the second connection electrode CE2 are disposed on the light emitting diode LED, but for the convenience of description, the light emitting diode LED is illustrated with a solid line. Further, for the convenience of description, among the configurations of the light emitting diode LED, emission layers 222, 232, and 242 are not illustrated. In FIG. 6, a cross-sectional view for a first sub pixel SP1 is illustrated. Other configurations of a display device 200 of FIGS. 5 and 6 are substantially the same as those of the display device 100 of FIGS. 1 to 4 except a light emitting diode LED, a first connection electrode CE1, and a second connection electrode CE2 so that a redundant description will be omitted. Further, in FIGS. 5 and 6, as illustrated in FIG. 3, it is illustrated that the light emitting diode LED includes two first electrodes 224, 234, and 244 and an example that among them, the light emitting diodes LED disposed in different sub pixels SP are configured with different sizes and shapes is specified.

First, referring to FIG. 5, the display panel PN includes a plurality of pixels PX which are formed by a plurality of sub pixels SP. Each of the plurality of sub pixels SP includes a light emitting diode LED and a pixel circuit to independently emit light. One pixel PX may include a first sub pixel SP1, a second sub pixel SP2, and a third sub pixel SP3. For example, one pixel PX may include one first sub pixel SP1, one second sub pixel SP2, and one third sub pixel SP3. At this time, the first sub pixel SP1 may be a red sub pixel, the second sub pixel SP2 may be a green sub pixel, and the third sub pixel SP3 may be a blue sub pixel, but they are not limited thereto.

A plurality of light emitting diodes ED may be disposed in the plurality of sub pixels SP. Specifically, the plurality of light emitting diodes LED includes a first light emitting diode 220, a second light emitting diode 230, and a third light emitting diode 240. The first light emitting diode 220 may be disposed in the first sub pixel SP1, the second light emitting diode 230 may be disposed in the second sub pixel SP2, and the third light emitting diode 240 may be disposed in the third sub pixel SP3. For example, the first light emitting diode 220 may be a red light emitting diode, the second light emitting diode 130 may be a green light emitting diode, and the third light emitting diode 240 may be a blue light emitting diode.

In addition, the first light emitting diode 220, the second light emitting diode 230, and the third light emitting diode 240 may be formed with different shapes. For example, a planar shape of the first light emitting diode 220 may be a circular shape and a planar shape of the second light emitting diode 230 and the third light emitting diode 240 may be an oval shape. At this time, the second light emitting diode 230 and the third light emitting diode 240 may have different sizes. In addition, a major axis direction of the second light emitting diode 230 and the third light emitting diode 240 may be the same, but the present disclosure is not limited thereto.

The first light emitting diode 220 may include a first semiconductor layer 221, an emission layer 222, a second semiconductor layer 223, a first electrode 224, a second electrode 225, and a passivation film 226. At this time, a planar shape of each of the first semiconductor layer 221, the emission layer 222, the second semiconductor layer 223, the first electrode 224, and the second electrode 225 may be a circular shape. Among them, the first electrode 224 is disposed along a circumference of the first semiconductor layer 221 to be formed as a closed-loop circular electrode. The second electrode 225 may be formed to have a shape corresponding to a top surface of the second semiconductor layer 223.

The second light emitting diode 230 may include a first semiconductor layer 231, an emission layer 232, a second semiconductor layer 233, a first electrode 234, a second electrode 235, and a passivation film 236. At this time, planar shapes of the first semiconductor layer 231, the second semiconductor layer 233, and the second electrode 235 of the second light emitting diode 230 may be oval shapes. At this time, a major axis direction of the first semiconductor layer 231 may be configured to be different from a major axis direction of the second semiconductor layer 233. For example, when the first semiconductor layer 231 has an oval shape having a major axis in a horizontal direction, the second semiconductor layer 233 may have an oval shape having a major axis in the vertical direction. The first electrode 234 may be disposed in each of both end portions of the first semiconductor layer 231 in the major axis direction, on the top surface of the first semiconductor layer 231. Accordingly, the plurality of first electrodes 234 disposed on both end portions of the first semiconductor layer 231 may be formed in a semi-circular shape. Finally, the second electrode 235 may be formed in an oval shape, as the same as the top surface of the second semiconductor layer 233.

The third light emitting diode 240 may include a first semiconductor layer 241, an emission layer 242, a second semiconductor layer 243, a first electrode 244, a second electrode 245, and a passivation film 246. At this time, planar shapes of the first semiconductor layer 241, the second semiconductor layer 243, and the second electrode 245 of the third light emitting diode 240 may be oval shapes. Unlike the second light emitting diode 230, in the third light emitting diode 240, the major axis direction of the first semiconductor layer 241 and the major axis direction of the second semiconductor layer 243 may be configured to be the same. The first electrode 244 is disposed in each of both end portions of the first semiconductor layer 241 in the major axis direction, on the top surface of the first semiconductor layer 241 and may be formed in a semi-circular shape. The second electrode 245 may be formed in an oval shape, as the same as the top surface of the second semiconductor layer 243. For example, in the display device 200 according to another exemplary embodiment of the present disclosure, the first light emitting diode 220, the second light emitting diode 230, and the third light emitting diode 240 are configured to have different shapes, respectively, to distinguish the plurality of light emitting diodes LED. For example, when the light emitting diode LED is self-assembled, the plurality of light emitting diodes LED is formed to have different shapes to be self-assembled in a position corresponding to each of the plurality of sub pixels SP. However, the shapes of the plurality of light emitting diodes LED are illustrative, so that it is not limited thereto.

Referring to FIGS. 5 and 6, a plurality of first connection electrodes CE1 and a plurality of second connection electrodes CE2 may be disposed on the plurality of light emitting diodes LED. The first connection electrode CE1 may include a plurality of first sub electrodes CE1a which are disposed to be spaced apart from each other and first base electrodes CE1b connected to the plurality of first sub electrodes CE1a. Similarly, the second connection electrode CE2 may include a plurality of second sub electrodes CE2a which are disposed to be spaced apart from each other and second base electrodes CE2b connected to the plurality of second sub electrodes CE2a.

Specifically, the plurality of first sub electrodes CE1a may be connected to the first electrodes 224, 234, and 244 of the plurality of light emitting diodes LED and the plurality of second sub electrodes CE2a may be connected to the second electrodes 225, 235, and 245 of the plurality of light emitting diodes LED. At this time, the plurality of first sub electrodes CE1a and the plurality of second sub electrodes CE2a may be alternately disposed on the plane to minimize or reduce the short defect. Accordingly, the plurality of first sub electrodes CE1a and the plurality of second sub electrodes CE2a may be disposed to be parallel on the plane. For example, the plurality of first sub electrodes CE1a and the plurality of second sub electrodes CE2a may be disposed to be parallel to the major axis direction of the second light emitting diode 230 and the third light emitting diode 240, but are not limited thereto.

At this time, referring to FIG. 6, a width t1 of the plurality of first sub electrodes CE1a may be equal to or smaller than an interval t4 between the plurality of second sub electrodes CE2a so that the plurality of second sub electrodes CE2a and the plurality of first sub electrodes CE1a do not overlap. Similarly, a width t3 of the plurality of second sub electrodes CE2a may be equal to or smaller than an interval t2 between the plurality of first sub electrodes CE1a. In addition, the width t1 of the plurality of first sub electrodes CE1a or the interval t4 between the plurality of second sub electrodes CE2a may be designed in various forms in consideration of a size and a shape of the light emitting diode LED or an interval between the first electrodes 224, 234, and 244 and the second electrodes 225, 235, and 245.

The first connection electrode CE1 and the second connection electrode CE2 may be formed of the same conductive material and for example, formed of a transparent conductive material, such as indium tin oxide (ITO) or indium zinc oxide (IZO), but are not limited thereto.

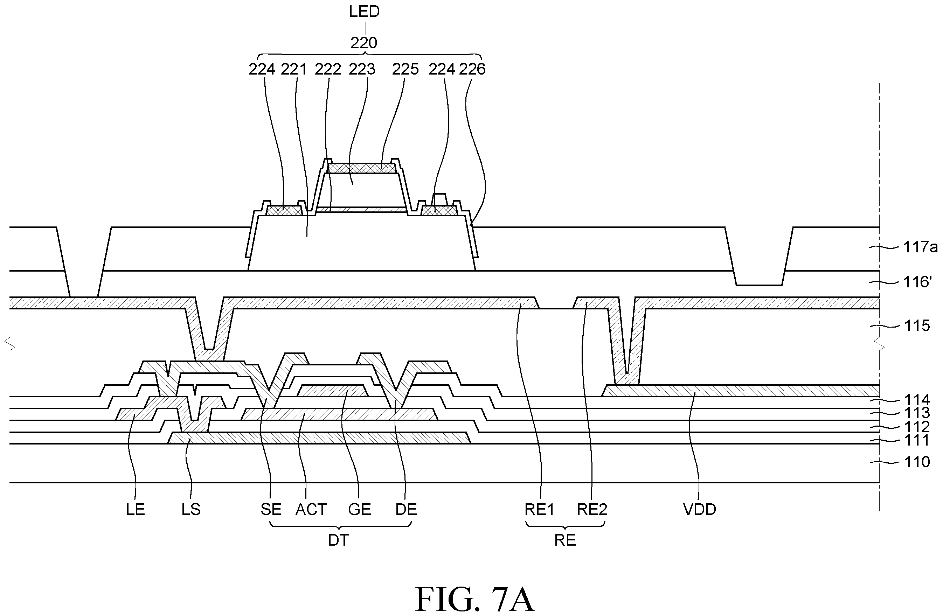

Hereinafter, a manufacturing method of a display device according to another exemplary embodiment of the present disclosure will be described in detail with reference to FIGS. 7A to 7F.

FIGS. 7A to 7F are process diagrams for explaining a manufacturing method of a display device according to another exemplary embodiment of the present disclosure.

First, referring to FIG. 7A, a process of etching a part of the adhesive layer 116 and the first planarization layer 117a to form a contact hole may be performed. A contact hole formed in this process is a contact hole through which the first reflective electrode RE1 is exposed.

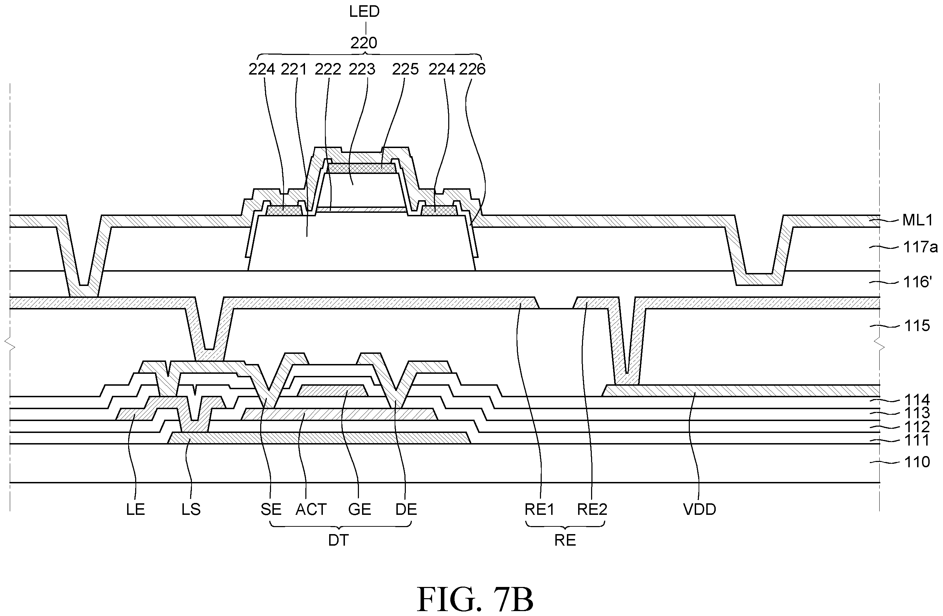

Next, referring to FIG. 7B, a first layer ML1 may be disposed on the first planarization layer 117a and the light emitting diode LED. The first layer ML1 is patterned by a subsequent process to become a plurality of first sub electrodes CE1a.

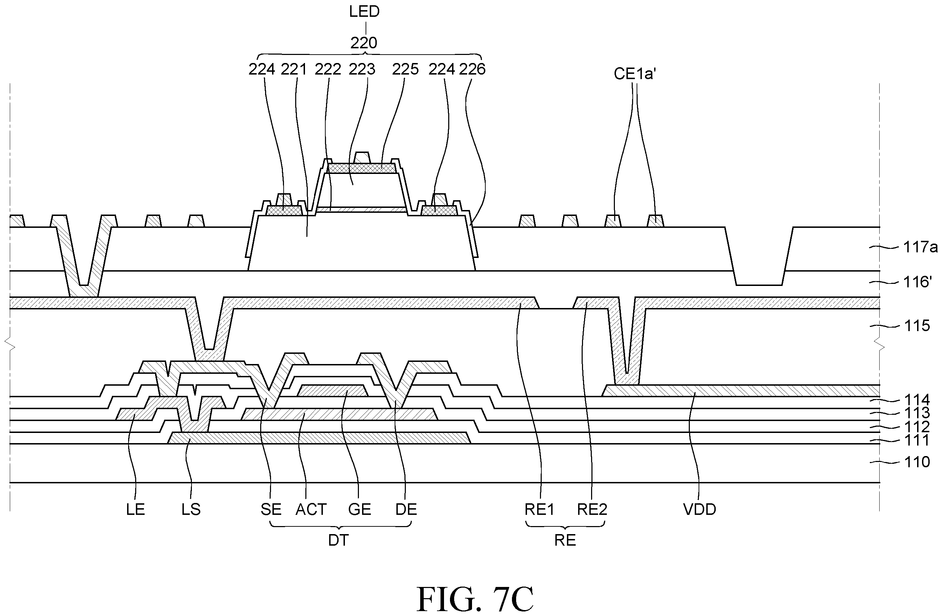

Next, referring to FIG. 7C, a process of patterning the first layer ML1 to form an initial first sub electrode CE1a' may be performed.

Specifically, a process of partially applying a photoresist on the first layer ML1, a process of selectively exposing and developing the photoresist, and a process of wet-etching the first layer ML1 are performed to form the initial first sub electrode CEla'. Therefore, the initial first sub electrodes CE1a' may be disposed on the first planarization layer 117a, the first electrodes 224, 234, and 244, and the second electrodes 225, 235, and 245 to be spaced apart from each other.

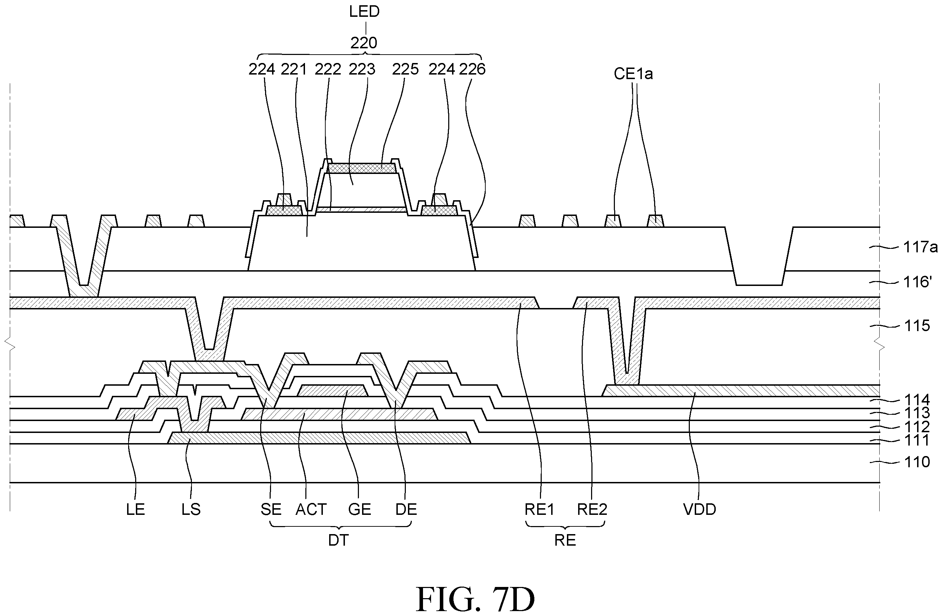

Next, referring to FIG. 7D, a process of removing the initial first sub electrode CEla' disposed on the second electrodes 225, 235, and 245 to form the first sub electrode CE1a may be performed.

Specifically, after applying the photoresist on the entire surface so as to cover the top surface of the light emitting diode LED, only the photoresist applied on the second electrodes 225, 235, and 245 is subject to the ashing process to be removed. For example, the photoresist is ashed to expose only the initial first sub electrode CEla' disposed on the second electrodes 225, 235, 245. Thereafter, the initial first sub electrode CEla' disposed on the second electrodes 225, 235, and 245 may be removed by the wet etching process.

Therefore, a part covered by the photoresist, for example, only the initial sub electrode CE1a' disposed on the first planarization layer 117a and the first electrode 124 may become the first sub electrode CE1a. For example, the first sub electrode CE1a of the first connection electrode CE1 is self-aligned with the first electrode 124 by the ashing process of the first planarization layer 117a and the photoresist to minimize or reduce the short defect according to the process error.

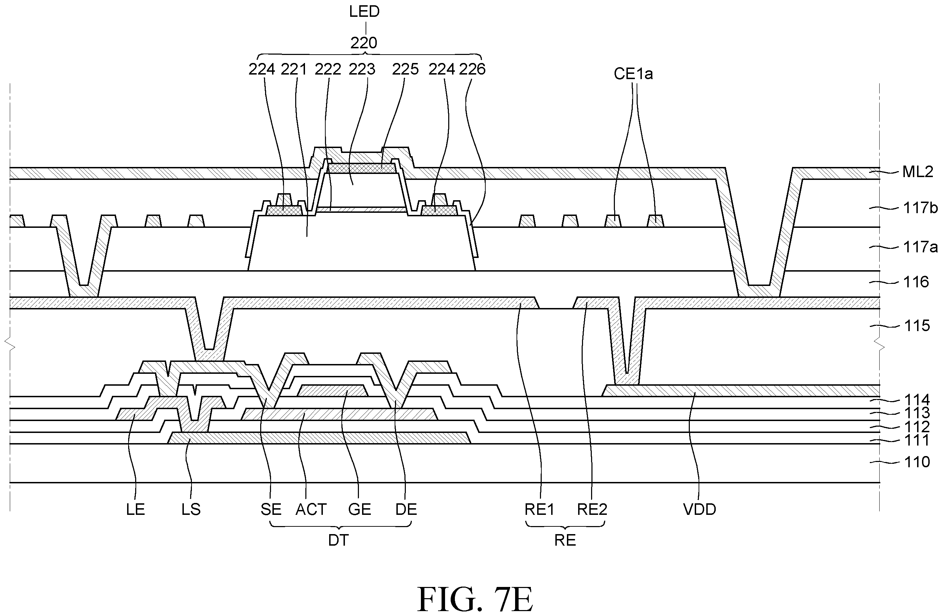

Next, referring to FIG. 7E, the second planarization layer 117b and the second layer ML2 may be sequentially disposed on the light emitting diode LED and the first planarization layer 117a.

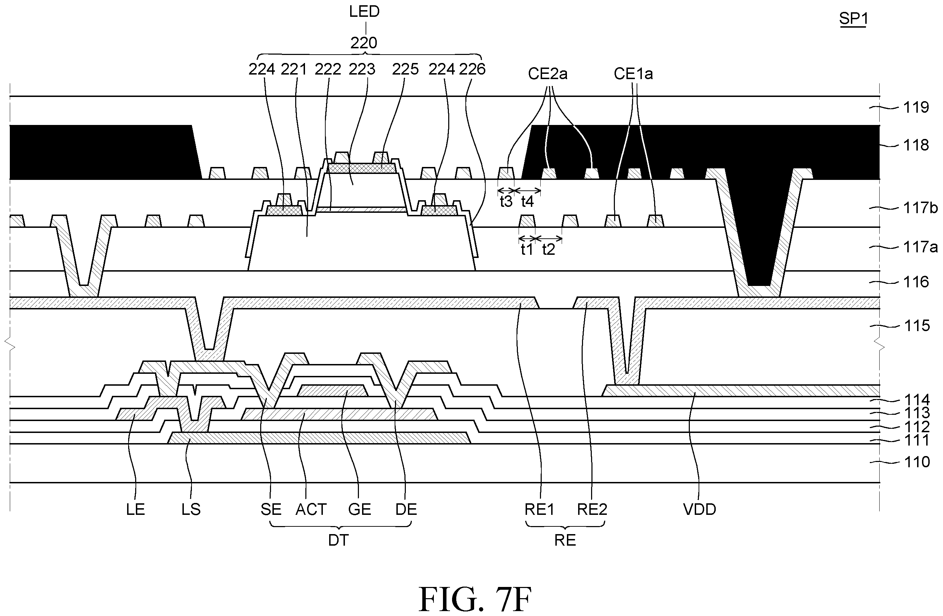

Specifically, the second planarization layer 117b may be disposed so as to expose the top surface of the light emitting diode LED. For example, after applying the material layer of the second planarization layer 117b so as to cover the top surface of the light emitting diode LED, the material layer of the second planarization layer 117b applied on the second electrodes 225, 235, and 245 may be partially ashed to be removed. Next, a dry-etching process for forming a contact hole which exposes the second reflective electrode RE2 may be performed. Next, a second layer ML2 may be disposed on the second planarization layer 117b and the contact hole. The second layer ML2 is patterned by a subsequent process to become a plurality of second sub electrodes CE2a. Finally, referring to FIG. 7F, the plurality of second sub electrodes CE2a may be formed by the patterning process of the second layer ML2.

Specifically, the patterning may be performed by the process of exposing the photoresist disposed on the second layer ML2 and the process of wet-etching the second layer ML2.

In addition, the second layer ML2 is disposed and patterned on the front surface of the substrate 110 including the second planarization layer 117b to form the plurality of second sub electrodes CE2a of the second connection electrode CE2. However, even in this case, the plurality of second sub electrodes CE2a may be in contact with only the top surface of the second electrode 125 exposed from the second planarization layer 117b and may be spaced apart from the first connection electrode CE1, the emission layer 122, and the first semiconductor layer 121 disposed below the second planarization layer 117b. Accordingly, the plurality of second sub electrodes CE2a may be in contact with only the top surface of the second electrode 125. Therefore, there is no need to ensure a process margin in consideration of positions of the first semiconductor layer 121 and the plurality of first sub electrodes CE1a during the formation of the plurality of second sub electrodes CE2a. For example, the light emitting diode LED and the plurality of second sub electrodes CE2a are self-aligned by the ashing process to minimize or reduce the short defect according to the process error.

Next, the bank 118 and the third planarization layer 119 are disposed on the plurality of second sub electrodes CE2a and the second planarization layer 117b to complete the manufacturing process of the display device 200.

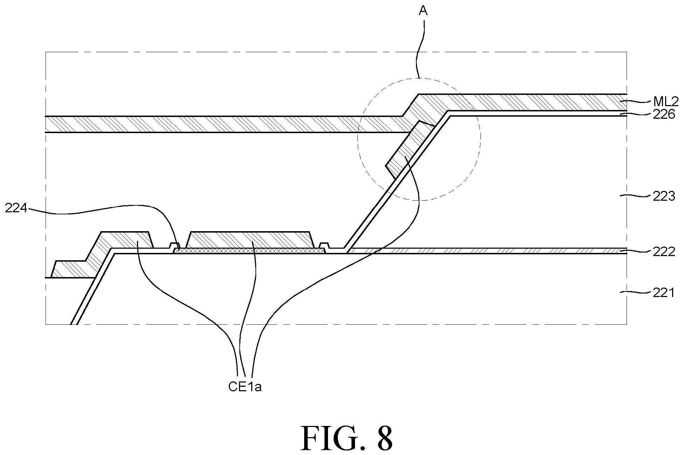

FIG. 8 is a view for explaining an effect according to a first connection electrode and a second connection electrode of a display device according to another exemplary embodiment of the present disclosure. In FIG. 8, for the convenience of description, only a part of the light emitting diode LED, the first planarization layer 117a, and the second planarization layer 117b are enlarged to be illustrated. FIG. 8 is a view for explaining a principle of suppressing the short defect of the first connection electrode CE1 and the second connection electrode CE2 and a situation in which the first sub electrode CE1a of the first connection electrode CE1 is disposed on side surfaces of the second semiconductor layers 223, 233, and 243 is assumed.

Referring to FIG. 7E and an area A of FIG. 8 together, the first sub electrode CE1a on the side surface of the second semiconductor layers 223, 233, and 243 may not be removed. Therefore, during the processing process, the first sub electrode CE1a and the second layer ML2 may be in contact with each other. At this time, the second layer ML2 is patterned to be alternately disposed with the plurality of first sub electrodes CE1a to suppress the short defect. For example, the second layer ML2 disposed in the area A is removed by the wet-etching to insulate the first sub electrode CE1a from the second layer ML2. At this time, the first sub electrode CE1a is already crystallized by the thermal treatment process of the second planarization layer 117b so that even though the patterning process of the second layer ML2 proceeds, the first sub electrode CE1a may remain without being etched. For example, even though the process error is generated, the plurality of second sub electrodes CE2a is patterned to be spaced apart from the plurality of first sub electrodes CE1a to suppress the short defect.

In the display device 200 according to another exemplary embodiment of the present disclosure, the first connection electrode CE1 connected to the first electrodes 224, 234, and 244 of the light emitting diode LED may be disposed on the first planarization layer 117a. For example, before placing the first connection electrode CE1, the first planarization layer 117a may be disposed. Therefore, even though during the processing process, the passivation films 226, 236, and 246 in the lower edge part of the light emitting diode LED are torn to cause the step with the nearby area, the first planarization layer 117a may be filled in the torn area of the passivation films 226, 236, and 246. For example, the first planarization layer 117a is disposed so as to enclose the lower edge part of the light emitting diode LED to separate the first connection electrode CE1 and the torn area of the passivation films 226, 236, and 246. Accordingly, the first planarization layer 117a is in contact with the torn area of the passivation films 226, 236, and 246 to minimize or reduce the short defect caused by the step between the torn area of the passivation films 226, 236, and 246 and a peripheral area.

Further, in the display device 200 according to another exemplary embodiment of the present disclosure, the first connection electrode CE1 and the first electrodes 224, 234, and 244 of the light emitting diode LED are self-aligned to be connected. For example, the material layer of the first planarization layer 117a may be disposed so as to enclose the light emitting diode LED. Next, the material layer of the first planarization layer 117a is subject to the ashing process to expose the first electrodes 224, 234, and 244. Next, the material layer of the first connection electrode CE1 may be disposed on the first planarization layer 117a. At this time, the photoresist may be applied on the material layer of the first connection electrode CE1 and the photoresist may be ashed until the second electrodes 225, 235, and 245 of the light emitting diode LED are exposed. Next, the material layer of the first connection electrode CE1 exposed by the ashing process is removed so that only the material layer of the first connection electrode CE1 disposed on the first electrode 124 and the first planarization layer 117a remains to form the first connection electrode CE1. Therefore, the first connection electrode CE1 and the first electrodes 224, 234, and 244 may be self-aligned by the ashing process of the first planarization layer 117a and the photoresist without precisely aligning the positions of the first electrodes 224, 234, and 244 and the first connection electrode CE1. Accordingly, the short defect according to the process error may be minimized or reduced.

Further, in the display device 200 according to another exemplary embodiment of the present disclosure, the second connection electrode CE2 and the second electrodes 225, 235, and 245 of the light emitting diode LED are self-aligned to be connected. For example, the ashing process is performed on the second planarization layer 117b which covers the second semiconductor layers 223, 233, and 243 and the second electrodes 225, 235, and 245 of the light emitting diode LED to expose only the second semiconductor layers 223, 233, and 243 and the second electrodes 225, 235, and 245 of the light emitting diode LED. Therefore, the second connection electrode CE2 is in contact with only top surfaces of the second electrodes 225, 235, and 245 exposed from the second planarization layer 117b and may be spaced apart from the first connection electrode CE1, the emission layers 222, 232, and 242, and the first semiconductor layers 221, 231, and 241 disposed below the second planarization layer 117b. Accordingly, the second connection electrode CE2 may be in contact with only the top surfaces of the second electrodes 225, 235, and 245. Therefore, there is no need to ensure a process margin in consideration of positions of the first semiconductor layers 221, 231, and 241 and the first connection electrode CE1 during the formation of the second connection electrode CE2. Therefore, the second connection electrode CE2 and the second electrodes 225, 235, and 245 may be self-aligned by the ashing process of the second planarization layer 117b without precisely aligning the positions of the second electrodes 225, 235, and 245 and the second connection electrode CE2. Accordingly, the short defect according to the process error may be minimized or reduced. Specifically, in the display device 200 according to another exemplary embodiment of the present disclosure, the first electrodes 224, 234, and 244 of the light emitting diode LED are connected to the plurality of first sub electrodes CE1a of the first connection electrode CE1 disposed on the first planarization layer 117a. Further, the second electrodes 225, 235, and 245 are connected to the plurality of second sub electrodes CE2a of the second connection electrode CE2 disposed on the second planarization layer 117b. At this time, after patterning the plurality of first sub electrodes CE1a, the plurality of second sub electrodes CE2a is patterned so as to be alternately disposed with the plurality of first sub electrodes on the plane. For example, the plurality of first sub electrodes CE1a and the plurality of second sub electrodes CE2a may be not only disposed to be separated in a Z-axis direction, but also disposed so as not to overlap on the XY plane. Therefore, even though the light emitting diodes LED are erroneously aligned or erroneously disposed, the short defect caused by the overlapping of the plurality of first sub electrodes CE1a and the plurality of second sub electrodes CE2a may be minimized or reduced.

Further, in the display device 200 according to another exemplary embodiment of the present disclosure, the plurality of first sub electrodes CE1a of the first connection electrode CE1 and the plurality of second sub electrodes CE2a of the second connection electrode CE2 are disposed to be spaced apart from each other. Therefore, when the defect is generated in the light emitting diode LED, only some first sub electrodes CE1a or some second sub electrodes CE2a which are in contact with a defective light emitting diode are cut with laser to be darkened. For example, the light emitting diode LED may be easily repaired. It is to be noted that, although FIGS. 3 to 8 show a detailed arrangement and layer structure of the display device, but it is only provided by way of example, and the present disclosure is not limited thereto. For example, the layer structure of the display device may be variously changed, and one or more of the interlayer insulating layers or the planarization layers may be omitted when necessary.

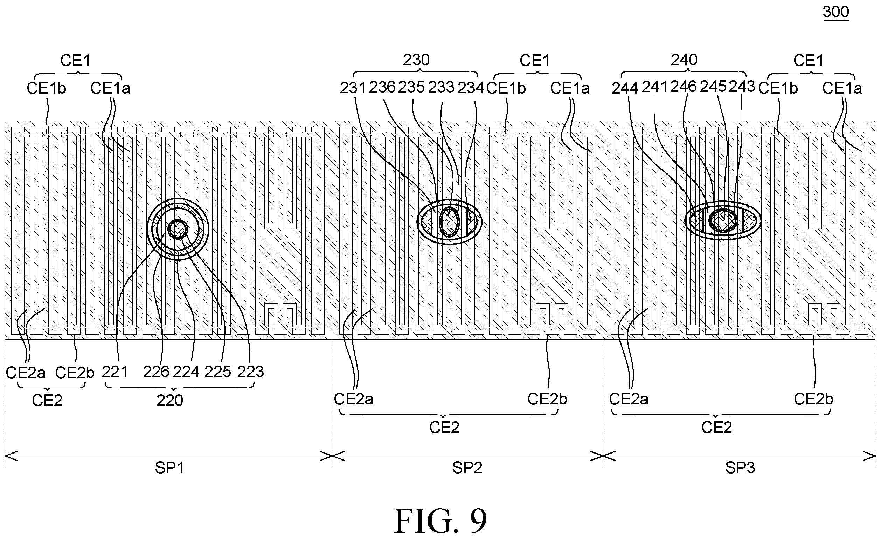

FIG. 9 is an enlarged plan view of a display device according to still another exemplary embodiment of the present disclosure. In FIG. 9, the light emitting element LED, the first connection electrode CE1, and the second connection electrode CE2, among various configurations of the display device 300, are illustrated. Due to the actual structure, the first connection electrode CE1 and the second connection electrode CE2 are disposed on the light emitting diode LED, but for the convenience of description, the light emitting diode LED is illustrated with a solid line. Further, for the convenience of description, among the configurations of the light emitting diode LED, emission layers 222, 232, and 242 are not illustrated. Other components of a display device 300 of FIG. 9 are substantially the same as those in the display device 200 of FIGS. 5 to 8 except a placement structure of the first connection electrode CE1 and the second connection electrode CE2, so that a redundant description will be omitted.

Referring to FIG. 9, a plurality of first connection electrodes CE1 and a plurality of second connection electrodes CE2 may be disposed on the plurality of light emitting diodes LED. The first connection electrode CE1 may include a plurality of first sub electrodes CE1a which are disposed to be spaced apart from each other and first base electrodes CE1b connected to the plurality of first sub electrodes CE1a. Similarly, the second connection electrode CE2 may include a plurality of second sub electrodes CE2a which are disposed to be spaced apart from each other and second base electrodes CE2b connected to the plurality of second sub electrodes CE2a.

Specifically, the plurality of first sub electrodes CE1a may be connected to the first electrodes 224, 234, and 244 of the plurality of light emitting diodes LED and the plurality of second sub electrodes CE2a may be connected to the second electrodes 225, 235, and 245 of the plurality of light emitting diodes LED. At this time, the plurality of first sub electrodes CE1a and the plurality of second sub electrodes CE2a may be alternately disposed on the plane to minimize or reduce the short defect. Accordingly, the plurality of first sub electrodes CE1a and the plurality of second sub electrodes CE2a may be disposed to be parallel on the plane. For example, the plurality of first sub electrodes CE1a and the plurality of second sub electrodes CE2a may be disposed to be perpendicular to the major axis direction of the second light emitting diode 230 and the third light emitting diode 240, but are not limited thereto.

In the display device 300 according to still another exemplary embodiment of the present disclosure, the first connection electrode CE1 connected to the first electrodes 224, 234, and 244 of the light emitting diode LED may be disposed on the first planarization layer 117a. For example, before placing the first connection electrode CE1, the first planarization layer 117a may be disposed. Therefore, even though during the processing process, the passivation films 226, 236, and 246 in the lower edge part of the light emitting diode LED are torn to cause the step with the nearby area, the first planarization layer 117a may be filled in the torn area of the passivation films 226, 236, and 246. For example, the first planarization layer 117a is disposed so as to enclose the lower edge part of the light emitting diode LED to separate the first connection electrode CE1 and the torn area of the passivation films 226, 236, and 246. Accordingly, the first planarization layer 117a is in contact with the torn area of the passivation films 226, 236, and 246 to minimize or reduce the short defect caused by the step between the torn area of the passivation films 226, 236, and 246 and a peripheral area.

Further, in the display device 300 according to still another exemplary embodiment of the present disclosure, the first connection electrode CE1 and the first electrodes 224, 234, and 244 of the light emitting diode LED are self-aligned to be connected. For example, the material layer of the first planarization layer 117a may be disposed so as to enclose the light emitting diode LED. Next, the material layer of the first planarization layer 117a is subject to the ashing process to expose the first electrodes 224, 234, and 244. Next, the material layer of the first connection electrode CE1 may be disposed on the first planarization layer 117a. At this time, the photoresist is applied on the material layer of the first connection electrode CE1 and the photoresist may be ashed until the second electrodes 225, 235, and 245 of the light emitting diode LED are exposed. Next, the material layer of the first connection electrode CE1 exposed by the ashing process is removed so that only the material layer of the first connection electrode CE1 disposed on the first electrodes 224, 234, and 244 and the first planarization layer 117a remains to form the first connection electrode CE1. Therefore, the first connection electrode CE1 and the first electrodes 224, 234, and 244 may be self-aligned by the ashing process of the first planarization layer 117a and the photoresist without precisely aligning the positions of the first electrodes 224, 234, and 244 and the first connection electrode CE1. Accordingly, the short defect according to the process error may be minimized or reduced.

Further, in the display device 300 according to still another exemplary embodiment of the present disclosure, the second connection electrode CE2 and the second electrodes 225, 235, and 245 of the light emitting diode LED are self-aligned to be connected. For example, the ashing process is performed on the second planarization layer 117b which covers the second semiconductor layers 223, 233, and 243 and the second electrodes 225, 235, and 245 of the light emitting diode LED to expose only the second semiconductor layers 223, 233, and 243 and the second electrodes 225, 235, and 245 of the light emitting diode LED. Therefore, the second connection electrode CE2 may be in contact with only top surfaces of the second electrodes 225, 235, and 245 exposed from the second planarization layer 117b and may be spaced apart from the first connection electrode CE1, the emission layers 222, 232, and 242, and the first semiconductor layers 221, 231, and 241 disposed below the second planarization layer 117b. Accordingly, the second connection electrode CE2 may be in contact with only the top surfaces of the second electrodes 225, 235, and 245. Therefore, there is no need to ensure a process margin in consideration of positions of the first semiconductor layers 221, 231, and 241 and the first connection electrode CE1 during the formation of the second connection electrode CE2. Therefore, the second connection electrode CE2 and the second electrodes 225, 235, and 245 may be self-aligned by the ashing process of the second planarization layer 117b without precisely aligning the positions of the second electrodes 225, 235, and 245 and the second connection electrode CE2. Accordingly, the short defect according to the process error may be minimized or reduced. Specifically, in the display device 300 according to still another exemplary embodiment of the present disclosure, the first electrodes 224, 234, and 244 of the light emitting diode LED are connected to the plurality of first sub electrodes CE1a of the first connection electrode CE1 disposed on the first planarization layer 117a. Further, the second electrodes 225, 235, and 245 are connected to the plurality of second sub electrodes CE2a of the second connection electrode CE2 disposed on the second planarization layer 117b. At this time, after patterning the plurality of first sub electrodes CE1a, the plurality of second sub electrodes CE2a is patterned so as to be alternately disposed with the plurality of first sub electrodes on the plane. For example, the plurality of first sub electrodes CE1a and the plurality of second sub electrodes CE2a may be not only disposed to be separated in a Z-axis direction, but also disposed so as not to overlap on the XY plane. Therefore, even though the light emitting diodes LED are erroneously aligned or erroneously disposed, the short defect caused by the overlapping of the plurality of first sub electrodes CE1a and the plurality of second sub electrodes CE2a may be minimized or reduced.

Further, in the display device 300 according to still another exemplary embodiment of the present disclosure, the plurality of first sub electrodes CE1a of the first connection electrode CE1 and the plurality of second sub electrodes CE2a of the second connection electrode CE2 are disposed to be spaced apart from each other. Therefore, when the defect is generated in the light emitting diode LED, only some first sub electrodes CE1a or some second sub electrodes CE2a which are in contact with a defective light emitting diode are cut with laser to be darkened. For example, the light emitting diode LED may be easily repaired.

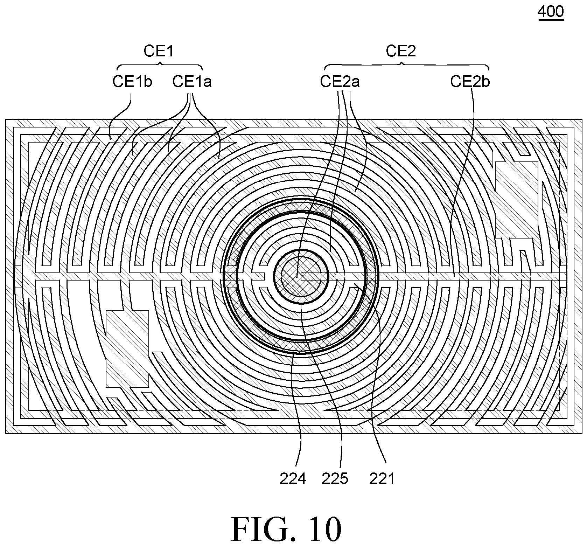

FIG. 10 is an enlarged plan view of a display device according to still another exemplary embodiment of the present disclosure. In FIG. 10, the light emitting element LED, the first connection electrode CE1, and the second connection electrode CE2, among various configurations of the display device 400, are illustrated. Further, in FIG. 10, in order to explain an effect of the first connection electrode CE1, and the second connection electrode CE2, only the part of the first sub pixel SP1 in which the first light emitting diode 220 is disposed is enlarged. Other components of a display device 400 of FIG. 10 are substantially the same as those in the display device 200 of FIGS. 5 to 8 except a structure of the first connection electrode CE1 and the second connection electrode CE2, so that a redundant description will be omitted.

Referring to FIG. 10, a plurality of first connection electrodes CE1 and a plurality of second connection electrodes CE2 may be disposed on the plurality of light emitting diodes LED. The first connection electrode CE1 may include a plurality of first sub electrodes CE1a which are disposed to be spaced apart from each other and first base electrodes CE1b connected to the plurality of first sub electrodes CE1a. Similarly, the second connection electrode CE2 may include a plurality of second sub electrodes CE2a which are disposed to be spaced apart from each other and second base electrodes CE2b connected to the plurality of second sub electrodes CE2a.

Specifically, the plurality of first sub electrodes CE1a may be connected to the first electrodes 224, 234, and 244 of the plurality of light emitting diodes LED and the plurality of second sub electrodes CE2a may be connected to the second electrodes 225, 235, and 245 of the plurality of light emitting diodes LED. At this time, the plurality of first sub electrodes CE1a and the plurality of second sub electrodes CE2a may be alternately disposed on the plane to minimize or reduce the short defect. Accordingly, the plurality of first sub electrodes CE1a and the plurality of second sub electrodes CE2a may be disposed to be parallel on the plane.

For example, like the first light emitting diode 220 disposed in the first sub pixel SP1, a planar shape of the light emitting diode may be a circular shape. In this case, the plurality of first sub electrodes CE1a of the first connection electrode CE1 disposed on the first light emitting diode 220 may have a circular shape with one open side on the plane, but it is not limited thereto. For example, the plurality of first sub electrodes CE1a may have a shape corresponding to a shape of the first electrode 224 of the first light emitting diode 220 so as to be easily electrically connected to the first electrode 224 of the first light emitting diode 220.

In addition, the plurality of first base electrodes CE1b of the first connection electrode CE1 is disposed in an area where the plurality of second sub electrodes CE2a of the second connection electrode CE2 is open to be connected to the plurality of first sub electrodes CE1a. Therefore, the first base electrode CE1b may have a straight line shape, unlike the plurality of first sub electrodes CE1a.

One of the plurality of second sub electrodes CE2a of the second connection electrode CE2 has a circular shape and the remaining second sub electrodes may have a circular shape with an open side, but are not limited thereto. For example, one of the plurality of second sub electrodes CE2a may have a shape corresponding to a shape of the second electrode 225 of the first light emitting diode 220 so as to be easily electrically connected to the second electrode 225 of the first light emitting diode 220. In addition, the plurality of second sub electrodes CE2a having a circular shape with an open side may be open in an opposite side to one open side of the plurality of first sub electrodes CE1a of the first connection electrode CE1. For example, the plurality of second sub electrodes CE2a having a circular shape with an open side may be disposed so as to face the plurality of first sub electrodes CE1a on the plane.

In addition, the plurality of second base electrodes CE2b of the second connection electrode CE2 are disposed in an area where the plurality of first sub electrodes CE1a is open to be connected to the plurality of second sub electrodes CE2a. Therefore, the second base electrode CE2b may have a straight line shape, unlike the plurality of second sub electrodes CE2a.

Accordingly, in the display device 400 according to still another exemplary embodiment of the present disclosure, the first connection electrode CE1 connected to the first electrodes 224, 234, and 244 of the light emitting diode LED may be disposed on the first planarization layer 117a. For example, before placing the first connection electrode CE1, the first planarization layer 117a may be disposed. Therefore, even though during the processing process, the passivation films 226, 236, and 246 in the lower edge part of the light emitting diode LED are torn to cause the step with the nearby area, the first planarization layer 117a may be filled in the torn area of the passivation films 226, 236, and 246. For example, the first planarization layer 117a is disposed so as to enclose the lower edge part of the light emitting diode LED to separate the first connection electrode CE1 and the torn area of the passivation films 226, 236, and 246. Accordingly, the first planarization layer 117a is in contact with the torn area of the passivation films 226, 236, and 246 to minimize or reduce the short defect caused by the step between the torn area of the passivation films 226, 236, and 246 and a peripheral area.

Further, in the display device 400 according to still another exemplary embodiment of the present disclosure, the first connection electrode CE1 and the first electrodes 224, 234, and 244 of the light emitting diode LED are self-aligned to be connected. For example, the material layer of the first planarization layer 117a may be disposed so as to enclose the light emitting diode LED. Next, the material layer of the first planarization layer 117a is subject to the ashing process to expose the first electrodes 224, 234, and 244. Next, the material layer of the first connection electrode CE1 may be disposed on the first planarization layer 117a. At this time, the photoresist is applied on the material layer of the first connection electrode CE1 and the photoresist may be ashed until the second electrodes 225, 235, and 245 of the light emitting diode LED are exposed. Next, the material layer of the first connection electrode CE1 exposed by the ashing process is removed so that only the material layer of the first connection electrode CE1 disposed on the first electrodes 224, 234, and 244 and the first planarization layer 117a remains to form the first connection electrode CE1. Therefore, the first connection electrode CE1 and the first electrodes 224, 234, and 244 may be self-aligned by the ashing process of the first planarization layer 117a and the photoresist without precisely aligning the positions of the first electrodes 224, 234, and 244 and the first connection electrode CE1. Accordingly, the short defect according to the process error may be minimized or reduced.

Further, in the display device 400 according to still another exemplary embodiment of the present disclosure, the second connection electrode CE2 and the second electrodes 225, 235, and 245 of the light emitting diode LED are self-aligned to be connected. For example, the ashing process is performed on the second planarization layer 117b which covers the second semiconductor layers 223, 233, and 243 and the second electrodes 225, 235, and 245 of the light emitting diode LED to expose only the second semiconductor layers 223, 233, and 243 and the second electrodes 225, 235, and 245 of the light emitting diode LED. Therefore, the second connection electrode CE2 may be in contact with only top surfaces of the second electrodes 225, 235, and 245 exposed from the second planarization layer 117b and may be spaced apart from the first connection electrode CE1, the emission layers 222, 232, and 242, and the first semiconductor layers 221, 231, and 241 disposed below the second planarization layer 117b. Accordingly, the second connection electrode CE2 may be in contact with only the top surfaces of the second electrodes 225, 235, and 245. Therefore, there is no need to ensure a process margin in consideration of positions of the first semiconductor layers 221, 231, and 241 and the first connection electrode CE1 during the formation of the second connection electrode CE2. Therefore, the second connection electrode CE2 and the second electrodes 225, 235, and 245 may be self-aligned by the ashing process of the second planarization layer 117b without precisely aligning the positions of the second electrodes 225, 235, and 245 and the second connection electrode CE2. Accordingly, the short defect according to the process error may be minimized or reduced.

Specifically, in the display device 400 according to still another exemplary embodiment of the present disclosure, the first electrodes 224, 234, and 244 of the light emitting diode LED are connected to the plurality of first sub electrodes CE1a of the first connection electrode CE1 disposed on the first planarization layer 117a. Further, the second electrodes 225, 235, and 245 are connected to the plurality of second sub electrodes CE2a of the second connection electrode CE2 disposed on the second planarization layer 117b. At this time, after patterning the plurality of first sub electrodes CE1a, the plurality of second sub electrodes CE2a is patterned so as to be alternately disposed with the plurality of first sub electrodes on the plane. For example, the plurality of first sub electrodes CE1a and the plurality of second sub electrodes CE2a may be not only disposed to be separated in a Z-axis direction, but also disposed so as not to overlap on the XY plane. Therefore, even though the light emitting diodes LED are erroneously aligned or erroneously disposed, the short defect caused by the overlapping of the plurality of first sub electrodes CE1a and the plurality of second sub electrodes CE2a may be minimized or reduced.

Further, in the display device 400 according to still another exemplary embodiment of the present disclosure, the plurality of first sub electrodes CE1a of the first connection electrode CE1 and the plurality of second sub electrodes CE2a of the second connection electrode CE2 are disposed to be spaced apart from each other. Therefore, when the defect is generated in the light emitting diode LED, only some first sub electrodes CE1a or some second sub electrodes CE2a which are in contact with a defective light emitting diode are cut with laser to be darkened. For example, the light emitting diode LED may be easily repaired.

Specifically, in the display device 400 according to still another exemplary embodiment of the present disclosure, the plurality of first sub electrodes CE1a of the first connection electrode CE1 and the plurality of second sub electrodes CE2a of the second connection electrode CE2 may have a shape corresponding to the first light emitting diode 220 having a circular planar shape. For example, the plurality of first sub electrodes CE1a of the first connection electrode CE1 connected to the first electrode 224 of the first light emitting diode 220 may have a circular shape with one open side. Further, one of the plurality of second sub electrodes CE2a of the second connection electrode CE2 connected to the second electrode 225 of the first light emitting diode 220 has a circular shape. Therefore, the first light emitting diode 220 and the first connection electrode CE1 and the second connection electrode CE2 may be easily electrically connected.

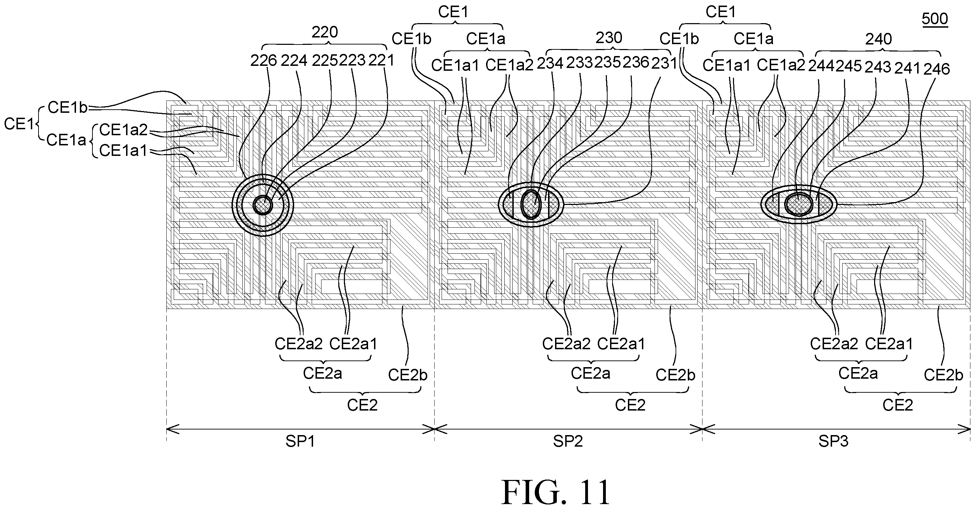

FIG. 11 is an enlarged plan view of a display device according to still another exemplary embodiment of the present disclosure. In FIG. 11, the light emitting element LED, the first connection electrode CE1, and the second connection electrode CE2, among various configurations of the display device 500, are illustrated. Due to the actual structure, the first connection electrode CE1 and the second connection electrode CE2 are disposed on the light emitting diode LED, but for the convenience of description, the light emitting diode LED is illustrated with a solid line. Further, for the convenience of description, among the configurations of the light emitting diode LED, emission layers 222, 232, and 242 are not illustrated. Other components of a display device 500 of FIG. 11 are substantially the same as those in the display device 200 of FIGS. 5 to 8 except a placement structure of the first connection electrode CE1 and the second connection electrode CE2, so that a redundant description will be omitted.

Referring to FIG. 11, a plurality of first connection electrodes CE1 and a plurality of second connection electrodes CE2 may be disposed on the plurality of light emitting diodes LED. The first connection electrode CE1 may include a plurality of first sub electrodes CE1a which are disposed to be spaced apart from each other and first base electrodes CE1b connected to the plurality of first sub electrodes CE1a. Similarly, the second connection electrode CE2 may include a plurality of second sub electrodes CE2a which are disposed to be spaced apart from each other and second base electrodes CE2b connected to the plurality of second sub electrodes CE2a.

Specifically, the plurality of first sub electrodes CE1a may be connected to the first electrodes 224, 234, and 244 of the plurality of light emitting diodes LED and the plurality of second sub electrodes CE2a may be connected to the second electrodes 225, 235, and 245 of the plurality of light emitting diodes LED. At this time, the plurality of first sub electrodes CE1a and the plurality of second sub electrodes CE2a may be alternately disposed on the plane to minimize or reduce the short defect. Accordingly, the plurality of first sub electrodes CE1a and the plurality of second sub electrodes CE2a may be disposed to be parallel on the plane.

For example, the plurality of first sub electrodes CE1a of the first connection electrode CE1 may include a first part CE1a1 extending in a first direction and a second part CE1a2 extending in a second direction on the plane. At this time, the first part CE1a1 and the second part CE1a2 may be disposed to be perpendicular to each other. For example, when the first direction is an x-axis direction, the second direction may be a y-axis direction. In contrast, when the first direction is a y-axis direction, the second direction may be an x-axis direction.

In the same way, the plurality of second sub electrodes CE2a of the second connection electrode CE2 may include a first part CE2a1 extending in the first direction and a second part CE2a2 extending in the second direction on the plane. At this time, the first part CE2a1 and the second part CE2a2 may be disposed to be perpendicular to each other. In the same way, when the first direction is an x-axis direction, the second direction may be a y-axis direction. In contrast, when the first direction is a y-axis direction, the second direction may be an x-axis direction.

At this time, in order to suppress the short defect caused when the plurality of first sub electrodes CE1a and the plurality of second sub electrodes CE2a disposed in the first direction overlap, the first part CE1a1 of the plurality of first sub electrodes CE1a and the first part CE2a1 of the plurality of second sub electrodes CE2a may be alternately disposed on the plane. In the same way, the second part CE1a2 of the plurality of first sub electrodes CE1a and the second part CE2a2 of the plurality of second sub electrodes CE2a disposed in the second direction may be alternately disposed on the plane so as not to overlap each other.

Accordingly, in the display device 500 according to still another exemplary embodiment of the present disclosure, the first connection electrode CE1 connected to the first electrodes 224, 234, and 244 of the light emitting diode LED may be disposed on the first planarization layer 117a. For example, before placing the first connection electrode CE1, the first planarization layer 117a may be disposed. Therefore, even though during the processing process, the passivation films 226, 236, and 246 in the lower edge part of the light emitting diode LED are torn to cause the step with the nearby area, the first planarization layer 117a may be filled in the torn area of the passivation films 226, 236, and 246. For example, the first planarization layer 117a is disposed so as to enclose the lower edge part of the light emitting diode LED to separate the first connection electrode CE1 and the torn area of the passivation films 226, 236, and 246. Accordingly, the first planarization layer 117a is in contact with the torn area of the passivation films 226, 236, and 246 to minimize or reduce the short defect caused by the step between the torn area of the passivation films 226, 236, and 246 and a peripheral area.

Further, in the display device 500 according to still another exemplary embodiment of the present disclosure, the first connection electrode CE1 and the first electrodes 224, 234, and 244 of the light emitting diode LED are self-aligned to be connected. For example, the material layer of the first planarization layer 117a may be disposed so as to enclose the light emitting diode LED. Next, the material layer of the first planarization layer 117a is subject to the ashing process to expose the first electrodes 224, 234, and 244. Next, the material layer of the first connection electrode CE1 may be disposed on the first planarization layer 117a. At this time, the photoresist is applied on the material layer of the first connection electrode CE1 and the photoresist may be ashed until the second electrodes 225, 235, and 245 of the light emitting diode LED are exposed. Next, the material layer of the first connection electrode CE1 exposed by the ashing process is removed so that only the material layer of the first connection electrode CE1 disposed on the first electrodes 224, 234, and 244 and the first planarization layer 117a remains to form the first connection electrode CE1. Therefore, the first connection electrode CE1 and the first electrodes 224, 234, and 244 may be self-aligned by the ashing process of the first planarization layer 117a and the photoresist without precisely aligning the positions of the first electrodes 224, 234, and 244 and the first connection electrode CE1. Accordingly, the short defect according to the process error may be minimized or reduced.

Further, in the display device 500 according to still another exemplary embodiment of the present disclosure, the second connection electrode CE2 and the second electrodes 225, 235, and 245 of the light emitting diode LED are self-aligned to be connected. For example, the ashing process is performed on the second planarization layer 117b which covers the second semiconductors layer 223, 233, and 243 and the second electrodes 225, 235, and 245 of the light emitting diode LED to expose only the second semiconductor layers 223, 233, and 243 and the second electrodes 225, 235, and 245 of the light emitting diode LED. Therefore, the second connection electrode CE2 may be in contact with only top surfaces of the second electrodes 225, 235, and 245 exposed from the second planarization layer 117b and may be spaced apart from the first connection electrode CE1, the emission layers 222, 232, and 242, and the first semiconductor layers 221, 231, and 241 disposed below the second planarization layer 117b. Accordingly, the second connection electrode CE2 may be in contact with only the top surfaces of the second electrodes 225, 235, and 245. Therefore, there is no need to ensure a process margin in consideration of positions of the first semiconductor layers 221, 231, and 241 and the first connection electrode CE1 during the formation of the second connection electrode CE2. Therefore, the second connection electrode CE2 and the second electrodes 225, 235, and 245 may be self-aligned by the ashing process of the second planarization layer 117b without precisely aligning the positions of the second electrodes 225, 235, and 245 and the second connection electrode CE2. Accordingly, the short defect according to the process error may be minimized or reduced.

Specifically, in the display device 500 according to still another exemplary embodiment of the present disclosure, the first electrodes 224, 234, and 244 of the light emitting diode LED are connected to the plurality of first sub electrodes CE1a of the first connection electrode CE1 disposed on the first planarization layer 117a. Further, the second electrodes 225, 235, and 245 are connected to the plurality of second sub electrodes CE2a of the second connection electrode CE2 disposed on the second planarization layer 117b. At this time, after patterning the plurality of first sub electrodes CE1a, the plurality of second sub electrodes CE2a is patterned so as to be alternately disposed with the plurality of first sub electrodes CE1a on the plane. For example, the plurality of first sub electrodes CE1a and the plurality of second sub electrodes CE2a may be not only disposed to be separated in a Z-axis direction, but also disposed so as not to overlap on the XY plane. Therefore, even though the light emitting diodes LED are erroneously aligned or erroneously disposed, the short defect caused by the overlapping of the plurality of first sub electrodes CE1a and the plurality of second sub electrodes CE2a may be minimized or reduced.

Further, in the display device 500 according to still another exemplary embodiment of the present disclosure, the plurality of first sub electrodes CE1a of the first connection electrode CE1 and the plurality of second sub electrodes CE2a of the second connection electrode CE2 are disposed to be spaced apart from each other. Therefore, when the defect is generated in the light emitting diode LED, only some first sub electrodes CE1a or some second sub electrodes CE2a which are in contact with a defective light emitting diode are cut with laser to be darkened. For example, the light emitting diode LED may be easily repaired.

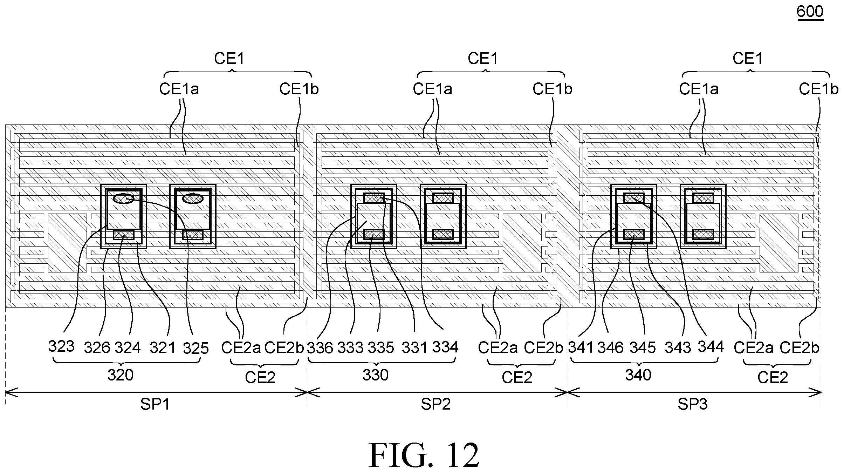

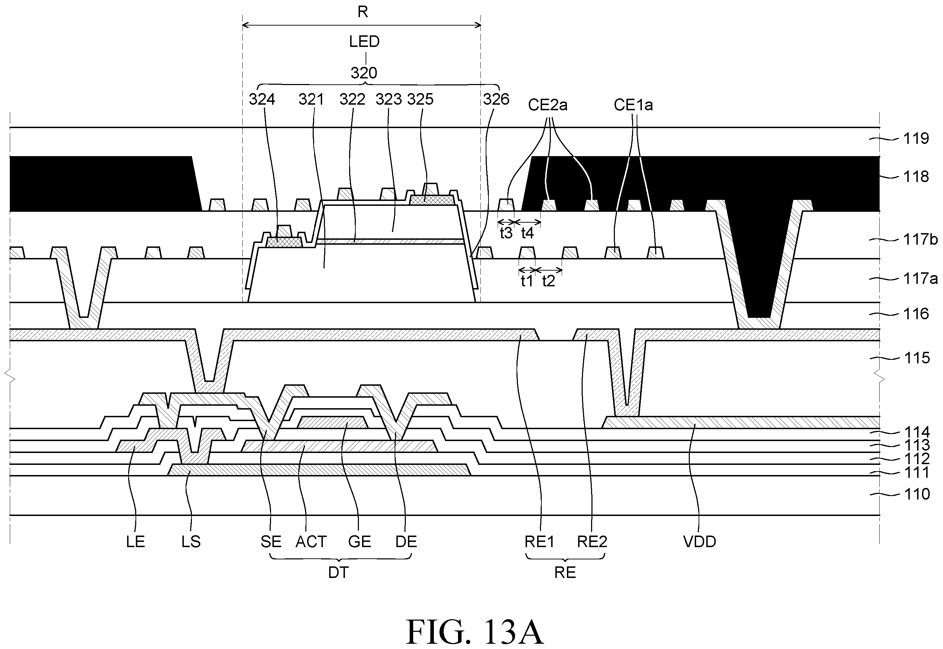

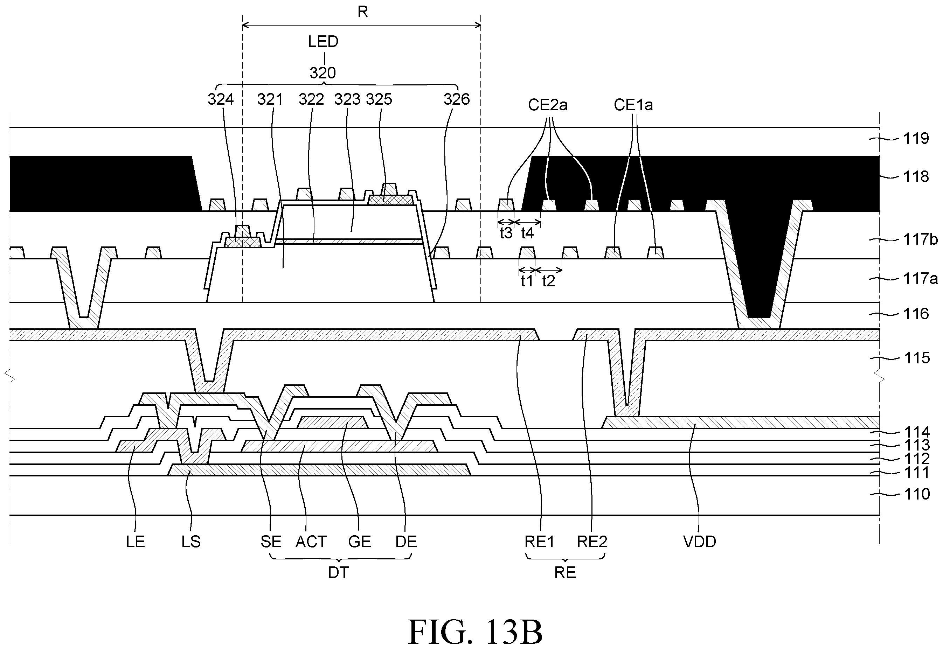

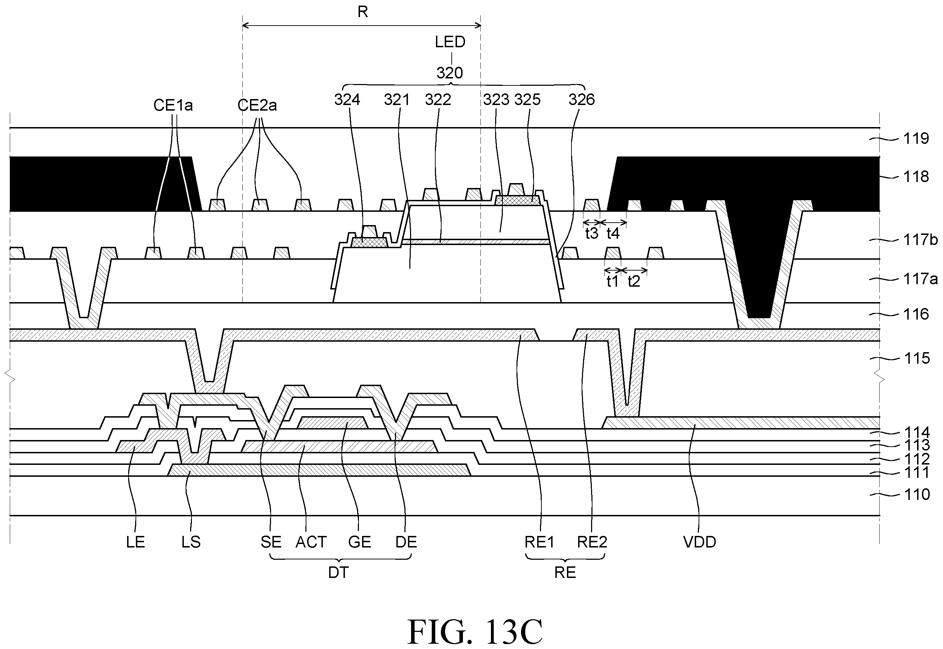

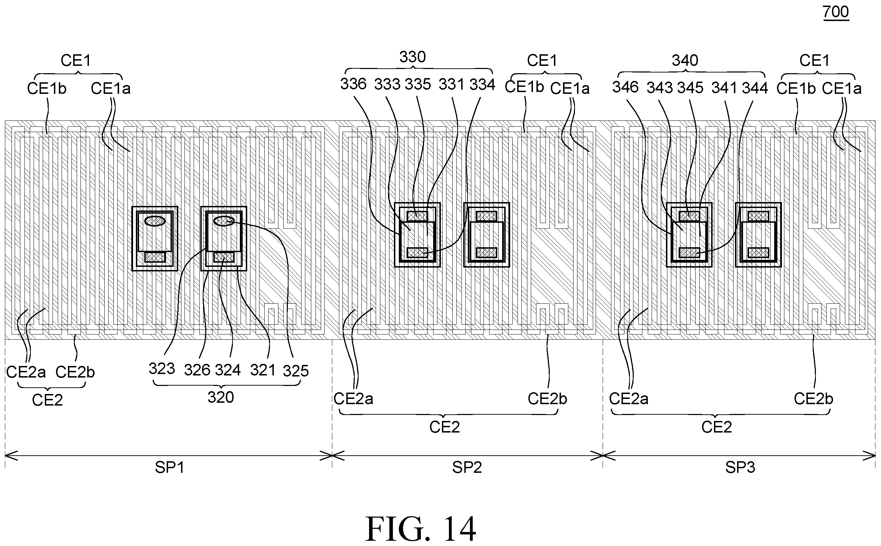

FIG. 12 is an enlarged plan view of a display device according to still another exemplary embodiment of the present disclosure. FIGS. 13A to 13C are cross-sectional views of a display device according to still another exemplary embodiment of the present disclosure. Specifically, FIG. 13A is a view illustrating that a light emitting diode LED is disposed in a correct position R without being erroneously aligned or erroneously transferred. FIGS. 13B and 13C are views illustrating that the light emitting diode LED is erroneously aligned or erroneously transferred so that the light emitting diode is not disposed in the correct position R. FIG. 14 is a cross-sectional view of a display device according to still another exemplary embodiment of the present disclosure.

In FIGS. 12 and 14, the light emitting element LED, the first connection electrode CE1, and the second connection electrode CE2, among various configurations of the display device 600, are illustrated. Due to the actual structure, the first connection electrode CE1 and the second connection electrode CE2 are disposed on the light emitting diode LED, but for the convenience of description, the light emitting diode LED is illustrated with a solid line. Further, for the convenience of description, among the configurations of the light emitting diode LED, emission layers 322, 332, and 342 are not illustrated. In addition, other components of a display device 600 of FIG. 12 and a display device 700 of FIG. 14 are substantially the same as those of the display device 200 of FIGS. 5 to 8 and the display device 300 of FIG. 9 except shapes of a first light emitting diode 320, a second light emitting diode 330, and a third light emitting diode 340. Therefore, a redundant description will be omitted. Further, in the display device 600 of FIGS. 12 to 14, as illustrated in FIG. 4, it is illustrated that the light emitting diode LED includes one first electrode 324, 334, or 344 and an example that the light emitting diodes LED disposed in different sub pixels SP are configured with the same size and shape is specified.

Referring to FIGS. 12 and 14, a plurality of light emitting diodes LED may be disposed in the plurality of sub pixels SP. Specifically, the plurality of light emitting diodes LED includes a first light emitting diode 320, a second light emitting diode 330, and a third light emitting diode 340. The first light emitting diode 320 may be disposed in the first sub pixel SP1, the second light emitting diode 330 may be disposed in the second sub pixel SP2, and the third light emitting diode 340 may be disposed in the third sub pixel SP3. For example, the first light emitting diode 320 may be a red light emitting diode, the second light emitting diode 330 may be a green light emitting diode, and the third light emitting diode 340 may be a blue light emitting diode.

In addition, all the first light emitting diode 320, the second light emitting diode 330, and the third light emitting diode 340 may have a rectangular planar shape. Further, major axis directions of the first light emitting diode 320, the second light emitting diode 330, and the third light emitting diode 340 may be the same, but the present disclosure is not limited thereto.

Referring to FIGS. 12 to 14 together, the first light emitting diode 320 includes a first semiconductor layer 321, an emission layer 322, a second semiconductor layer 323, a first electrode 324, a second electrode 325, and a passivation film 326. At this time, a planar shape of each of the first semiconductor layer 321, the emission layer 322, the second semiconductor layer 323, and the first electrode 324 may be a rectangular shape, but a planar shape of the second electrode 325 may be an oval shape. Among them, the major axis direction of the first semiconductor layer 321, the emission layer 322, and the second semiconductor layer 323 may be the same as the major axis direction of the first light emitting diode 320. In contrast, the major axis direction of the first electrode 324 and the second electrode 325 may be different from the major axis direction of the first light emitting diode 320.

The second light emitting diode 330 includes a first semiconductor layer 331, an emission layer 332, a second semiconductor layer 333, a first electrode 334, a second electrode 335, and a passivation film 336. At this time, planar shapes of the first semiconductor layer 331, the second semiconductor layer 333, and the second electrode 335 of the second light emitting diode 330 may be rectangular shapes.

Among them, the major axis direction of the first semiconductor layer 331, the emission layer 332, and the second semiconductor layer 333 may be the same as the major axis direction of the first light emitting diode 320. In contrast, the major axis direction of the first electrode 334 and the second electrode 335 may be different from the major axis direction of the first light emitting diode 320.

The third light emitting diode 340 includes a first semiconductor layer 341, an emission layer 342, a second semiconductor layer 343, a first electrode 344, a second electrode 345, and a passivation film 346. At this time, planar shapes of the first semiconductor layer 341, the second semiconductor layer 343, and the second electrode 345 of the third light emitting diode 340 may be rectangular shapes.

Among them, the major axis direction of the first semiconductor layer 341, the emission layer 342, and the second semiconductor layer 343 may be the same as the major axis direction of the first light emitting diode 320. In contrast, the major axis direction of the first electrode 344 and the second electrode 345 may be different from the major axis direction of the first light emitting diode 320.

For example, in the display device 600 according to still another exemplary embodiment of the present disclosure, the first light emitting diode 320, the second light emitting diode 330, and the third light emitting diode 340 may have the same shape. Therefore, the plurality of light emitting diodes LED is transferred using a separate substrate, rather than the self-assembling method, to dispose the plurality of light emitting diodes LED in a position corresponding to each of the plurality of sub pixels SP. However, the shapes of the plurality of light emitting diodes LED are illustrative, so that it is not limited thereto.

A plurality of first connection electrodes CE1 and a plurality of second connection electrodes CE2 may be disposed on the plurality of light emitting diodes LED. The first connection electrode CE1 may include a plurality of first sub electrodes CE1a which are disposed to be spaced apart from each other and first base electrodes CE1b connected to the plurality of first sub electrodes CE1a. Similarly, the second connection electrode CE2 may include a plurality of second sub electrodes CE2a which are disposed to be spaced apart from each other and second base electrodes CE2b connected to the plurality of second sub electrodes CE2a.

Specifically, the plurality of first sub electrodes CE1a may be connected to the first electrodes 324, 334, and 344 of the plurality of light emitting diodes LED and the plurality of second sub electrodes CE2a may be connected to the second electrodes 325, 335, and 345 of the plurality of light emitting diodes LED. At this time, the plurality of first sub electrodes CE1a and the plurality of second sub electrodes CE2a may be alternately disposed on the plane to minimize or reduce the short defect. Accordingly, the plurality of first sub electrodes CE1a and the plurality of second sub electrodes CE2a may be disposed to be parallel on the plane. For example, the plurality of first sub electrodes CE1a and the plurality of second sub electrodes CE2a may be disposed to be parallel to the major axis direction of the first light emitting diode 320, the second light emitting diode 330, and the third light emitting diode 340, but are not limited thereto.

Referring to FIG. 13A, a width t1 of the plurality of first sub electrodes CE1a may be equal to or smaller than an interval t4 between the plurality of second sub electrodes CE2a so that the plurality of second sub electrodes CE2a and the plurality of first sub electrodes CE1a do not overlap. In addition, the width t1 of the plurality of first sub electrodes CE1a or the interval t4 between the plurality of second sub electrodes CE2a may be designed in various forms in consideration of a size and a shape of the light emitting diode LED or an interval between the first electrodes 324, 334, and 344 and the second electrodes 325, 335, and 345.

The first connection electrode CE1 and the second connection electrode CE2 may be formed of the same conductive material and for example, formed of a transparent conductive material, such as indium tin oxide (ITO) or indium zinc oxide (IZO), but are not limited thereto.

Referring to FIGS. 13B and 13C, the light emitting diode LED is erroneously aligned or erroneously transferred to be disposed to be biased to the left side or the right side from the correct position R, without being disposed in the correct position R. Also in this case, the first sub electrode CE1a may be alternately disposed with the second sub electrode CE2a of the second connection electrode CE2 on the plane. For example, even though the light emitting diode LED is erroneously transferred or erroneously aligned, after patterning the plurality of first sub electrodes CE1a of the first connection electrode CE1, the plurality of second sub electrodes CE2a of the second connection electrode CE2 is patterned so as not to overlap the plurality of first sub electrodes CE1a. Therefore, the short defect may be minimized or reduced.

Therefore, a width t1 of the plurality of first sub electrodes CE1a may be equal to or smaller than an interval t4 between the plurality of second sub electrodes CE2a so that the plurality of second sub electrodes CE2a and the plurality of first sub electrodes CE1a do not overlap. Similarly, a width t3 of the plurality of second sub electrodes CE2a may be equal to or smaller than an interval t2 between the plurality of first sub electrodes CE1a. In addition, the width t1 of the plurality of first sub electrodes CE1a or the interval t4 between the plurality of second sub electrodes CE2a may be designed in various forms in consideration of a size and a shape of the light emitting diode LED or an interval between the first electrodes 324, 334, and 344 and the second electrodes 325, 335, and 345.

In the display devices 600 and 700 according to still another exemplary embodiment of the present disclosure, the first connection electrode CE1 connected to the first electrodes 324, 334, and 344 of the light emitting diode LED may be disposed on the first planarization layer 117a. For example, before placing the first connection electrode CE1, the first planarization layer 117a may be disposed. Therefore, even though during the processing process, the passivation films 326, 336, and 346 in the lower edge part of the light emitting diode LED are torn to cause the step with the nearby area, the first planarization layer 117a may be filled in the torn area of the passivation films 326, 336, and 346. For example, the first planarization layer 117a is disposed so as to enclose the lower edge part of the light emitting diode LED to separate the first connection electrode CE1 and the torn area of the passivation films 326, 336, 346. Accordingly, the first planarization layer 117a is in contact with the torn area of the passivation films 326, 336, and 346 to minimize or reduce the short defect caused by the step between the torn area of the passivation films 326, 336, and 346 and a peripheral area.

Further, in the display devices 600 and 700 according to still another exemplary embodiment of the present disclosure, the first connection electrode CE1 and the first electrodes 324, 334, and 344 of the light emitting diode LED are self-aligned to be connected. For example, the material layer of the first planarization layer 117a may be disposed so as to enclose the light emitting diode LED. Next, the material layer of the first planarization layer 117a is subject to the ashing process to expose the first electrodes 324, 334, and 344. Next, the material layer of the first connection electrode CE1 may be disposed on the first planarization layer 117a. At this time, the photoresist is applied on the material layer of the first connection electrode CE1 and the photoresist may be ashed until the second electrodes 325, 335, and 345 of the light emitting diode LED are exposed. Next, the material layer of the first connection electrode CE1 exposed by the ashing process is removed so that only the material layer of the first connection electrode CE1 disposed on the first electrodes 324, 334, and 344 and the first planarization layer 117a remains to form the first connection electrode CE1. Therefore, the first connection electrode CE1 and the first electrodes 324, 334, and 344 may be self-aligned by the ashing process of the first planarization layer 117a and the photoresist without precisely aligning the positions of the first electrode 324, 334, and 344 and the first connection electrode CE 1. Accordingly, the short defect according to the process error may be minimized or reduced.

Further, in the display devices 600 and 700 according to still another exemplary embodiment of the present disclosure, the second connection electrode CE2 and the second electrodes 325, 335, and 345 of the light emitting diode LED are self-aligned to be connected. For example, the ashing process is performed on the second planarization layer 117b which covers the second semiconductor layers 323, 333, and 343 and the second electrodes 325, 335, and 345 of the light emitting diode LED to expose only the second semiconductor layers 323, 333, and 343 and the second electrodes 325, 335, and 345 of the light emitting diode LED. Therefore, the second connection electrode CE2 may be in contact with only top surfaces of the second electrodes 325, 335, and 345 exposed from the second planarization layer 117b and may be spaced apart from the first connection electrode CE1, the emission layers 322, 332, and 342, and the first semiconductor layers 321, 331, and 341 disposed below the second planarization layer 117b. Accordingly, the second connection electrode CE2 may be in contact with only the top surfaces of the second electrodes 325, 335, and 345. Therefore, there is no need to ensure a process margin in consideration of positions of the first semiconductor layers 321, 331, and 341 and the first connection electrode CE1 during the formation of the second connection electrode CE2. Therefore, the second connection electrode CE2 and the second electrodes 325, 335, and 345 may be self-aligned by the ashing process of the second planarization layer 117b without precisely aligning the positions of the second electrodes 325, 335, and 345 and the second connection electrode CE2. Accordingly, the short defect according to the process error may be minimized or reduced.

Specifically, in the display devices 600 and 700 according to still another exemplary embodiment of the present disclosure, the light emitting diodes LED may have the same size or shape. For example, the light emitting diode LED is transferred onto a separate transferring substrate, rather than a self-assembling method, to be disposed in locations corresponding to the plurality of sub pixels SP. In addition, the first electrodes 324, 334, and 344 of the light emitting diode LED are connected to the plurality of first sub electrodes CE1a of the first connection electrode CE1 disposed on the first planarization layer 117a. Further, the second electrodes 325, 335, and 345 are connected to the plurality of second sub electrodes CE2a of the second connection electrode CE2 disposed on the second planarization layer 117b. At this time, after patterning the plurality of first sub electrodes CE1a, the plurality of second sub electrodes CE2a is patterned so as to be alternately disposed with the plurality of first sub electrodes on the plane. For example, the plurality of first sub electrodes CE1a and the plurality of second sub electrodes CE2a may be not only disposed to be separated in the Z-axis direction, but also disposed so as not to overlap on the XY plane. Therefore, even though the light emitting diodes LED are erroneously aligned or erroneously disposed, the short defect caused by the overlapping of the plurality of first sub electrodes CE1a and the plurality of second sub electrodes CE2a may be minimized or reduced.

Further, in the display devices 600 and 700 according to still another exemplary embodiment of the present disclosure, the plurality of first sub electrodes CE1a of the first connection electrode CE1 and the plurality of second sub electrodes CE2a of the second connection electrode CE2 are disposed to be spaced apart from each other. Therefore, when the defect is generated in the light emitting diode LED, only some first sub electrodes CE1a or some second sub electrodes CE2a which are in contact with a defective light emitting diode are cut with laser to be darkened. For example, the light emitting diode LED may be easily repaired.

Although the embodiments of the disclosure have been described in detail with reference to the accompanying drawings, the disclosure is not limited thereto and may be embodied in many different forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all embodiments and do not limit the present disclosure. All the technical concepts in the equivalent scope of the present disclosure should be construed as falling within the scope of the disclosure.

## Claims

1. A display device, comprising:
a substrate (110) including a plurality of sub pixels (SP);
a plurality of light emitting diodes (LED) on the substrate (110) in the plurality of sub pixels (SP), each of the plurality of light emitting diodes (LED) includes a first electrode (124) and a second electrode (125) in a position higher than the first electrode (124) ;
a first planarization layer (117a) on the substrate (110) enclosing a part of a side surface of the plurality of light emitting diodes (LED);
a plurality of first connection electrodes (CE1) on the first planarization layer(117a) and connected to first electrodes (124) of the light emitting diodes (LED) respectively;
a second planarization layer (117b) on the first planarization layer (117a) and on the plurality of first connection electrodes (CE1); and
a plurality of second connection electrodes (CE2) on the second planarization layer (117b) and connected to second electrodes (125) of the light emitting diodes (LED) respectively.

2. The display device according to claim 1, wherein a height of an upper surface of the first planarization layer (117a) is lower than a height of an upper surface of the first electrode (124) and/or a height of an upper surface of the second planarization layer (117b) is lower than a height of an upper surface of the second electrode (125), preferably the part of the side surfaces of the light emitting diodes (LED) is in contact with the first planarization layer (117a).

3. The display device according to claim 1 or 2, wherein the second planarization layer (117b) is between the first connection electrodes (CE1) and the second connection electrodes (CE2) and fully covers the plurality of first connection electrodes (117a).

4. The display device according to any one of the preceding claims, further comprising:
a bank (118) on the second planarization layer (117b), the bank (118) is non-overlapping with the light emitting diodes (LED); preferably further comprising a third planarization layer (119) on the second planarization layer (117b) and the bank (118).

5. The display device according to any one of the preceding claims, wherein the plurality of first connection electrodes (CE1) includes a plurality of first sub electrodes (CE1a) spaced apart from each other,
the plurality of second connection electrodes (CE2) includes a plurality of second sub electrodes (CE2a) spaced apart from each other, and
preferably the plurality of first sub electrodes (CE1a) and the plurality of second sub electrodes(CE2a) are alternately disposed and/or the plurality of first sub electrodes (CE1a) and the plurality of second sub electrodes (CE2a) are parallel.

6. The display device according to claim 5, wherein the plurality of first connection electrodes (CE1a) further includes first base electrodes (CE1b) connected to the plurality of first sub electrodes (CE1a), and the plurality of second connection electrodes (CE2a) further includes second base electrodes (CE2b) connected to the plurality of second sub electrodes (CE2a).

7. The display device according to claim 5 or 6, wherein a width of each of the plurality of first sub electrodes (CE1a) is equal to or smaller than an interval between the plurality of second sub electrodes (CE2a) and/or a width of each of the plurality of second sub electrodes (CE2a) is equal to or smaller than an interval between the plurality of first sub electrodes (CE1a).

8. The display device according to any one of the preceding claims 5-7, wherein the light emitting diodes (LED) includes a first light emitting diode (220) having a circular planar shape, a second light emitting diode (230) having an oval planar shape, and a third light emitting diode (240) having an oval planar shape having a different size than the second light emitting diode (230),
wherein a major axis direction of the second light emitting diode (230) and a major axis direction of the third light emitting diode (240) are a same.

9. The display device according to claim 8, wherein the plurality of first sub electrodes (CE1a) and the plurality of second sub electrodes (CE2a) are parallel to the major axis direction of the second light emitting diode (230) and the third light emitting diode (240) or the plurality of first sub electrodes (CE1a) and the plurality of second sub electrodes (CE2a) are perpendicular to the major axis direction of the second light emitting diode (230) and the third light emitting diode (240).

10. The display device according to any one of the preceding claims 5-9, wherein the light emitting diodes includes a first light emitting diode (220) having a circular planar shape,
wherein the plurality of first sub electrodes (CE1a) connected to the first light emitting diode (220) has a circular shape with one open side on the plane, and
wherein one of the plurality of second sub electrodes (CE2a) connected to the first light emitting diode (220) has a circular shape and others of the plurality of second sub electrodes (CE2a) have a circular shape in which another side opposite to the one open side of the plurality of first sub electrodes (CEla) is open.

11. The display device according to claim 10, wherein the plurality of first connection electrodes (CE1) further includes first base electrodes (CE1b) connected to the plurality of first sub electrodes (CE1a) are in an open area of the plurality of second sub electrodes (CE2a), and the plurality of second connection electrodes (CE2) further includes second base electrodes (CE2b) connected to the plurality of second sub electrodes (CE2a) and are in an open area of the plurality of first sub electrodes (CE1a).

12. The display device according to any one of the preceding claims 5-11, wherein the plurality of first sub electrodes (CE1a) includes a first part (CE1a1) extending in a first direction and a second part (CE1a2) extending in a second direction different from the first direction on the plane, and the plurality of second sub electrodes (CE2a) includes a first part (CE2a1) extending in the first direction and a second part (CE2a2) extending in the second direction,
preferably the first part (CE1a1) of the first sub electrodes (CE1a) and the first part (CE2a1) of the second sub electrodes (CE2a) are alternately disposed on the plane, and the second part (CE1a2) of the first sub electrodes and the second part (CE1a2) of the second sub electrodes are alternately disposed on the plane.

13. The display device according to any one of the preceding claims 5-12, wherein the first sub electrodes (CE1a) and the second sub electrodes are non-overlapping with each other on the plane.

14. The display device according to any one of the preceding claims, further comprising:
a plurality of driving transistors (DT) on the substrate (110); and
a power line (VDD) on the substrate (110),
wherein the plurality of first connection electrodes (CE1) electrically connect the plurality of driving transistors (DT) and the first electrode (124) and the plurality of second connection electrodes (CE2) electrically connect the power line (VDD) and the second electrode (125).

15. The display device according to any one of the preceding claims, wherein each of the plurality of light emitting diodes (LED) includes at least one semiconductor layer (221, 223), preferably a first semiconductor layer (221) is below the first electrode (124) and in contact with the first electrode (124), and/or a passivation film (226) that surrounds at least partly the first semiconductor layer (221), wherein the first planarization layer (117a) fully covers a lower end of the passivation film (226).
